**Europäisches Patentamt**

**European Patent Office**

**Office européen des brevets**

(11) Veröffentlichungsnummer : **0 308 660 B1**

(12) **EUROPÄISCHE PATENTSCHRIFT**

(45) Veröffentlichungstag der Patentschrift :
24.05.95 Patentblatt 95/21

(51) Int. Cl.$^6$ : **G06F 11/26,** G06F 11/16, G06F 11/20

(21) Anmeldenummer : **88113627.9**

(22) Anmeldetag : **22.08.88**

(54) **Vorrichtung zur Herstellung einer testkompatiblen, weitgehend fehlertoleranten Konfiguration von redundant implementierten systolischen VLSI-Systemen.**

(30) Priorität : **22.09.87 DE 3731833**

(43) Veröffentlichungstag der Anmeldung :
**29.03.89 Patentblatt 89/13**

(45) Bekanntmachung des Hinweises auf die Patenterteilung :
**24.05.95 Patentblatt 95/21**

(84) Benannte Vertragsstaaten :
**DE FR GB IT**

(56) Entgegenhaltungen :
**EP-A- 0 223 690**
**YIELD MODELLING AND DEFECT TOLERANCE IN VLSI, PAPERS PRESENTED AT THEINTERNATIONAL WORKSHOP ON DESIGNING FOR YIELD, Oxford, 1.-3. Juli 1987, pages 233-245, Adam Hilger, Bristol, GB; U. RAMACHER: "A cost orientated redundancy model for defect-tolerant VLSI/WSI systems"**

(56) Entgegenhaltungen :
**AFIPS CONFERENCE PROCEEDINGS OF THE 1983 NATIONAL COMPUTER CONFERENCE, Anaheim,16.-19. Mai 1988, Seiten 565-577, AFIPS Press, Arlington, Virginia, US; M. SAMlet al.: "Reconfigurable architectures for VLSI processing arrays"**
**PROCEEDINGS OF THE FIRST INTERNATIONAL CONFERENCE ON COMPUTER TECHNOLOGY,SYSTEMS AND APPLICATIONS, Hamburg, 11.-15. Mai 1987, Seiten 480-483, IEEE, NewYork, US; V. BLASCHKE et al.: "Modular built-in testprocessor for VLSIchips"**
**WAFER SCALE INTEGRATION, II, PROCEEDINGS OF THE SECOND IFIP WG 10.5 WORKSHOP ON WAFER SCALE INTEGRATION, Egham, 23.-25. September 1987, Seiten 51-61, Elsevier Science Publisher B.V., (North-Holland), Amsterdam, NL: U. RAMACHER et al.: "A self testing WSI matrix-matrix multiplier"**

(73) Patentinhaber : **SIEMENS AKTIENGESELLSCHAFT**
**Wittelsbacherplatz 2**
**D-80333 München (DE)**

(72) Erfinder : **Ramacher, Ulrich, Dr. rer. nat.**
**Deisenhofener Strasse 4**
**D-8000 München 90 (DE)**
Erfinder : **Beichter, Jörg, Dipl.-Ing.**
**Naupliastrasse 1**
**D-8000 München 90 (DE)**

## Beschreibung

Eine großflächige fehlertolerante VLSI-Integration, wie beispielsweise die LAI (Large Area Integration) oder WSI (Wafer Scale Integration), ist ein Beitrag zur Integration von Systemen mit einer sehr hohen Anzahl von über $10^6$ Transistoren. Diese Systeme können in bewährter CMOS-Technologie entworfen werden und erreichen heute schon Größenordnungen, welche erst mit zukünftiger Submikrontechnologie verfügbar sind. Konfigurationsalgorithmen und Konfigurationsprozeduren haben hierbei die Aufgabe, aus einer Menge von redundant implementierten Funktionsmodulen eine Untermenge von funktionierenden Modulen ausfindig zu machen und Verbindungen zu aktivieren, so daß eine vorgegebene Funktion (beispielsweise ein Algorithmus oder eine Folge von Befehlen) auf der konfigurierten Menge ablauffähig ist. Eine Voraussetzung für redundante Implementation liegt darin, daß sie nur in solchen Systemen realisiert werden können, deren Architektur ein hohes Maß an Regularität aufweist. Systolische Felder sind hier sehr gut geeignet. Ein Algorithmus, welcher die Abbildung auf ein zweidimensionales systolisches Feld erlaubt, ist beispielsweise eine Matrix-Matrix-Multiplikation. Für eine großflächige monolithische Integration sind anzustreben:

a) Fehlertoleranz, das heißt in der Hardware-Realisierung der Konfigurationsprozedur auftretende Effekte verhindern nicht eine Konfigurierbarkeit des Gesamtsystems,

b) Testkompatibilität, das heißt der für nicht redundanten Entwurf nötige Systemtest ist ohne Mehraufwand an Hardware verwendbar für das redundant implementierte System, deckt die beschriebenen Defekte auf und aktiviert eine neue Konfiguration,

c) ein minimaler Hardwarebedarf.

Für eindimensionale Felder ist ein effektiver Algorithmus bei Aubusson und Catt "Wafer Scale Integration - A Fault-Tolerant Procedure" in IEEE J. Solid State, Vol. SC-13, No. 3, June 1978, Seiten 339-344 beschrieben. Andere Veröffentlichungen sind unter den Verfassern J. H. Kim, S. M. Reddy "On the design of easily testable and reconfigurable VLSI processor arrays", Workshop on designing for Yield, Oxford 1987, Seiten 273-282 angeführt, die jedoch die Forderungen nach a) Testkompatibilität und b) Fehlertoleranz und c) minimaler Hardwareaufwand nur sehr eingeschränkt erfüllen. In der Veröffentlichung "Reconfiguration Architectures for VLSI Processing Arrays" Proc. of IEEE, May, 1986, Seite 712 bis 722 von M. Sami and R. Steffanelli sind großflächige monolithische Integrationen beschrieben, die jedoch alle drei Forderungen Fehlertoleranz, Testkompatibilität und minimaler Hardwarebedarf überhaupt nicht erfüllen.

Systolische Felder sind aufgrund ihrer Regularität sehr gut geeignet für einen redundanten Systementwurf. Ein effektiver Konfigurationsalgorithmus, jedoch nur für eindimensionale systolische Felder, ist in der bereits genannten Veröffentlichung von Aubusson und Catt beschrieben. Eine Konfigurationsprozedur für zweidimensionale systolische Felder, welche die Eigenschaften a) Fehlertoleranz, b) Testkompatibilität und c) minimaler Hardwarebedarf aufweisen, können aus dieser Veröffentlichung jedoch nicht abgeleitet werden.

Aus der Veröffentlichung von Dr. Ramacher zum Thema "A Cost Orientated Redundancy Model for Defect-Tolerant VLSI/WSI-Systems", Proc. of the workshop on the designing for yield, Oxford, 1-3 July 1987, Adam Hilger, Bristol and Philadelphia, Seiten 233 bis 245 ist eine Vorrichtung nach dem Oberbegriff des Patentanspruchs 1 bekannt, bei der die lokale Steuerlogik in eine fehlertolerante Logik zum Setzen der Schalter und in eine fehlerintolerante Logik zum Übertrag der Fehlerinformation aufgespalten ist, wobei die lokale Steuerlogik durch insgesamt fünf logische Eingangsvariable angesteuert wird.

Der Erfindung liegt die Aufgabe zugrunde, eine Vorrichtung zur Konfiguration für redundant implementierte systolische VLSI-Systeme anzugeben, bei der die Bedingungen a) Fehlertoleranz, b) Testkompatibilität und c) minimaler Hardwarebedarf erfüllt sind, bei der eine redundante lokale Steuerlogik vorgesehen ist, bei der eine Fehlinformation nur bis zum Modul der nächsten Zeile gelangt und bei der diese Fehlinformation bei einer Neukonfiguration berücksichtigt wird.

Diese Aufgabe wird erfindungsgemäß durch die im kennzeichnenden Teil des ersten Patentanspruchs angegebenen Merkmale gelöst.

Weitere Ausgestaltungen der Erfindung sind in den Unteransprüchen angegeben und werden dort näher erläutert.

Da das Verfahren zur Konfiguration des VLSI-Systems (Konfigurationsalgorithmus) sich auf eine Matrix-Matrix-Multipliktion bezieht, ergibt sich als Vorzug, daß die einzelnen Module des systolischen Feldes von einer einfachen Struktur sind, dennoch lassen sich hier in voller Allgemeinheit diejenigen Probleme erkennen, welche mit Konfiguration und Test systolischer Felder einhergehen. Der hier vorgestellte Konfigurationsalgorithmus ist deshalb ohne Einschränkung übertragbar, beispielsweise auf ein zweidimensionales Feld von RISC-Prozessoren. Der Entwurf eines solchen LAI/WSI-Systems kann sich dann konzentrieren auf die systolische Abbildung einer genügend großen Menge von Algorithmen aus dem Bereich der allgemeinen und intelligenten Musterverarbeitung (Sprach- und Bildverarbeitung).

Ein Ausführungsbeispiel der Erfindung ist in den Zeichnungen dargestellt und wird im folgenden näher beschrieben. Es zeigen:

Figur 1 die Anordnung zur Durchführung des Konfigurationsalgorithmus für ein redundant implementiertes systolisches VLSI-System,

Figur 2 eine Anordnung des erfindungsgemäßen VLSI-Systems zur Durchführung einer Matrix-
Matrix-Multiplikation,

Figur 3 die Eingabe der Eingangsvariablen zur Matrix-Matrix-Multiplikation,

Figur 4 eine Verschaltung der einzelnen Module untereinander in einem VLSI-System,

Figur 5 ein Blockschaltbild der zu jedem Modul gehörenden erfindungsgemäßen Steuerlogik, zur
Ansteuerung der A-, B-, C-Schalter eines jeden Moduls,

Figur 6 eine Schaltung auf Gatterebene für die Steuerlogik nach Figur 5,

Figur 7a bis c Fehlerkonfigurationen, welche den Schalter B1 aktivieren,

Figur 7d Schaltungsrealisierung auf Gatterebene für die Ansteuerung des Schalters B1,

Figur 8a, b Fehlerkonfigurationen, welche den Schalter B2 aktivieren,

Figur 8c Schaltungsrealisierung auf Gatterebene für die Ansteuerung des Schalters B2,

Figur 9a, b Fehlerkonfigurationen, welche den Schalter B3 aktivieren,

Figur 9c Schaltungsrealisierung auf Gatterebene für die Ansteuerung des Schalters B3,

Figur 10a, b Fehlerkonfiguration, welche den Schalter B4 aktivieren,

Figur 10c Schaltungsrealisierung auf Gatterebene für die Ansteuerung des Schalters B4,

Figur 11a, b Fehlerkonfigurationen, welche den Schalter B5 aktivieren,

Figur 11c Schaltungsrealisierung auf Gatterebene für die Ansteuerung des Schalters B5,

Figur 12 Gatterrealisierung für die Ansteuerung der Schalter A bzw. C.

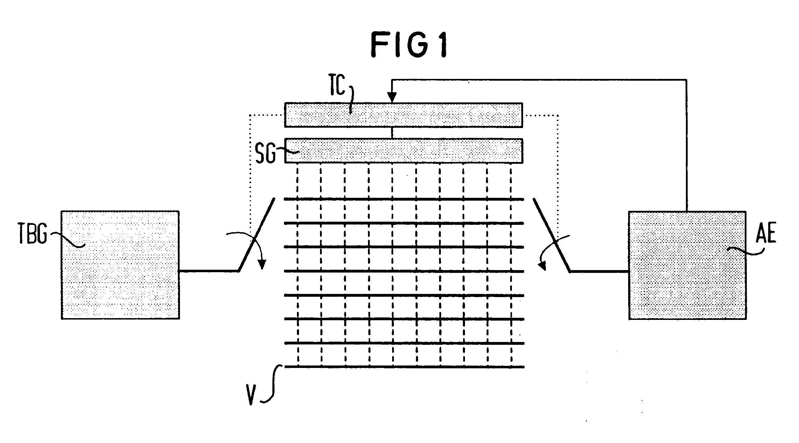

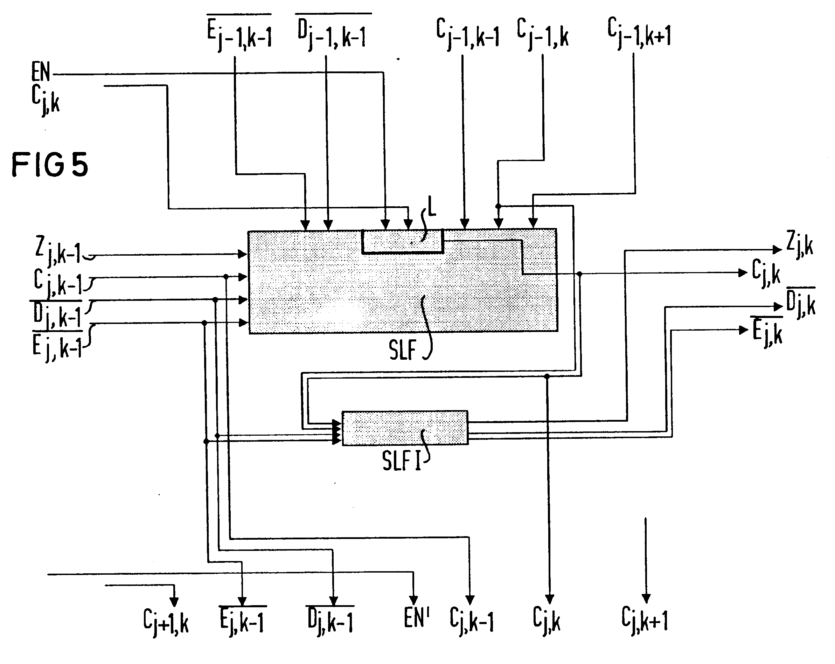

Die Vorrichtung zur Herstellung einer testkompatiblen, weitgehend fehlertoleranten Konfiguration für redundant implementierte systolische VLSI-Systeme beinhaltet nach Figur 1 ein aus der Gesamtzahl N' in Zeilen und Spalten angeordnete Module bestehendes VLSI-System V, eine Taktablaufsteuerung TC, einen Testbitgenerator TBG, eine Auswerteeinheit AE und einen Selektorbitgenerator SG. Die Taktablaufsteuerung TC, die den Ablauf des gesamten Testvorgangs steuert, einen Satz von Selektorbits über den Selektorbitgenerator SG ausgibt, und schließlich zeilenweise die Module für den Testvorgang ein- bzw. ausschaltet, ist zum einen mit dem Selektorbitgenerator SG, zum anderen zeilenweise mit nicht eingezeichneten Steuereingängen auf dem VLSI-System, der in der Figur 1 durch Schalter an beiden Seiten des Systems angedeutet sind und in Figur 5 näher erläutert werden, verbunden. Je ein Selektorbit schaltet dabei die Module in einer Spalte des VLSI-Systems entsprechend seiner 0/1-Belegung ein oder aus und mit Hilfe von "Enable"-Signalen an den Steuereingängen des VLSI-Systems werden die Module in der gewünschten Zeile aktiviert. Der Testbitgenerator TBG zur Lieferung der Eingangsvariablen ist zeilenweise mit den Eingängen des VLSI-Systems V verbunden, während die Auswerteeinheit zur Prüfung des Ergebnisses der ausgeführten Rechenoperationen aus den Eingangsvariablen zeilenweise mit den Ausgängen des VLSI-Systems verschaltet ist.

Die Größe des hier verwendeten VLSI-Systems beträgt 8x10 Module, wobei die vorgesehene Matrix-Matrix-Multiplikation lediglich 8 x 8 Module benötigt. Um eine bestimmt Anzahl, in diesem Falle 8, von funktionierenden Modulen aus einer großen Anzahl von in diesem Falle 10 redundant implementierten Modulen zu einem gewünschten System zusammenzubinden, bedarf es zweier Schritte:

a) des Aufbaus eines Leitungsnetzes für Ausgangsdaten für jede beliebige Kombination von 8 aus 10 Modulen,

b) des Tests jedes solchen Aufbaus durch Eingabe von Testmustern repräsentiert durch logische Eingangsvariablen aus dem Testbitgenerator und Auswertung der Ausgangsmuster repräsentiert durch Ausgangsvariablen in der Auswerteeinheit AE.

Das Verfahren zur Herstellung einer testkompatiblen, weitgehend fehlertoleranten Konfiguration für redundant implementierte systolische VLSI-Systeme sieht zunächst das zeilenweise Prüfen der einzelnen Module vor. Mit Hilfe des Selektorbitgenerators SG und "Enable"-Signalen an den Steuereingängen des VLSI-Systems V werden die einzelnen Module in einer Zeile entsprechend der 0/1-Belegung von Selektorbits funktionsfähig oder funktionsunfähig geschaltet. Im vorgegebenen Fall bleiben dabei jeweils zeilenweise 8 von 10 Modulen in Betrieb. Nach Aktivierung der einzelnen Module werden die A- und B-Eingangsvariablen zunächst für die erste Zeile an die Eingänge des VLSI-Systems angelegt.

Die Ergebnisse der ausgeführten Rechenoperation, in diesem Fall eine Multiplikation der Eingangsvariablen, wird an den Ausgängen des VLSI-Systems jeweils zeilenweise abgegriffen und einer Auswerteeinheit AE zugeführt. Bei einem negativen Ergebnis der ausgeführten Rechenoperationen wird für die Zeile eine neue 0/1-Belegung von Selektorbits aus dem Selektorbitgenerator SG erzeugt und eine neue Auswahl von in diesem Falle 8 von 10 Modulen zur Durchführung der Rechenoperationen ausgewählt. Dieser Testvorgang wird so oft wiederholt, bis entweder alle 45 Möglichkeiten einer 8 aus 10-Konfiguration der Module in einer Zeile ausgetestet wurden, oder bis eine Konfiguration gefunden wurde, die ein positives Ergebnis bei den durchgeführten Rechenoperationen liefert. Ist dies der Fall, so werden die hierfür verwendeten Selektorbits in der erfindungsgemäßen Steuerlogik, die in Figur 5 erläutert wird, abgespeichert. Anschließend werden unter der Durchführung der obengenannten Verfahrensschritte die Module in der zweiten, dritten und allen weiteren Zeilen des VLSI-Systems ausgetestet.

Bei den vorgesehenen Rechenoperationen handelt es sich um eine Matrix-Matrix-Multiplikation, die entsprechend definiert ist als

$$c_{i,k} = \sum_{j=0}^{N} a_{ij} \cdot b_{j,k} \, ,$$

für i, k = 1 bis N, in diesem Falle stellen $a_{ij}$ und $b_{jk}$ Eingangsvariablen und $C_{jk}$ Ausgangsvariablen für die Rechenoperation dar. Zur Prüfung der Module in der ersten Zeile ergebeb sich hieraus für die Eingangsvariablen folgende Kombinationen:

$a_1.b_1, a_1.b_2,...a_1.b_8$

mit

$a_1 := (a_{11}, a_{12},...a_{18})$,
$b_1 := (b_{11}, b_{21},...b_{81})$,
$b_2 := (b_{12}, b_{22},...b_{82})$,
$b_8 := (b_{18}, b_{28},...b_{88})$.

Als Ausgangsvariable ergibt sich für die erste Zeile $c_1 = (c_{11}, c_{12},...c_{18})$.

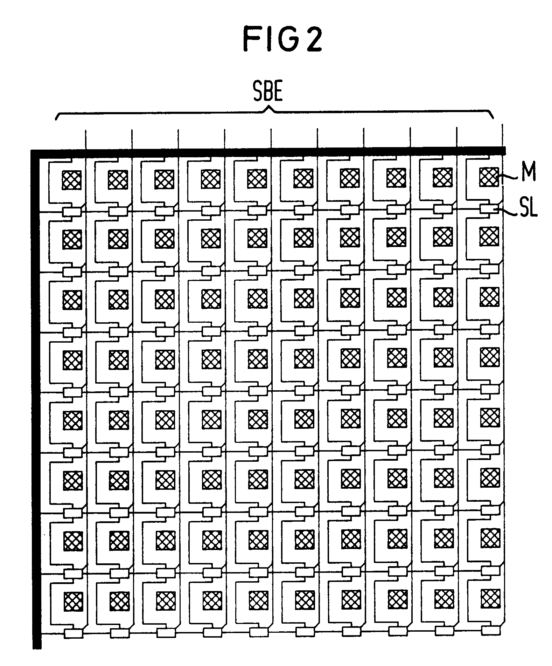

Figur 2 zeigt die spalten- und zeilenweise Anordnung der Module M innerhalb eines VLSI-Systems. Die Verschaltung der einzelnen Module M untereinander ist hierbei zur Vereinfachung nicht dargestellt. Man erkennt, daß jedem Modul M eine Steuerlogik SL zugeordnet ist, die zur Aktivierung der Schalter des entsprechenden Moduls M dient.

Die Steuerlogikschaltungen der Module einer Spalte werden jeweils von einem gemeinsamen Selektorbiteingang bedient, während die Aktivierung der Module zeilenweise durch Zuführung eines hier nicht eingezeichneten "Enable"-Signals, welches jeder Steuerlogik in einer Zeile gemeinsam zugeführt wird. Durch dieses "Enable"-Signal und der 0/1-Belegung der Selektorbits an den Selektorbiteingängen SBE ist es möglich, die Module zeilenweise auszutesten. Die Regularität des systolischen Feldes erfordert eine Verschaltung der Steuerlogiken untereinander, so daß eine Steuerlogik eines Moduls mit je vier anderen Steuerlogiken, die sich in unmittelbarer Nachbarschaft derselben befinden, verbunden sind. Dies trifft nicht für die Steuerlogiken zu, die sich an der Peripherie des VLSI-Systems befinden. Hier werden die benachbarten Steuerlogiken ersetzt, durch ein Verschalten der peripheren Steuerlogiken mit fest vorgegebenen 0- oder 1-Logikpegeln. Dies ist in Figur 2 durch die Verbindung der peripheren Steuerlogiken mit der äußeren Balkenbegrenzung angedeutet, und wird in Figur 5 nochmals näher erläutert.

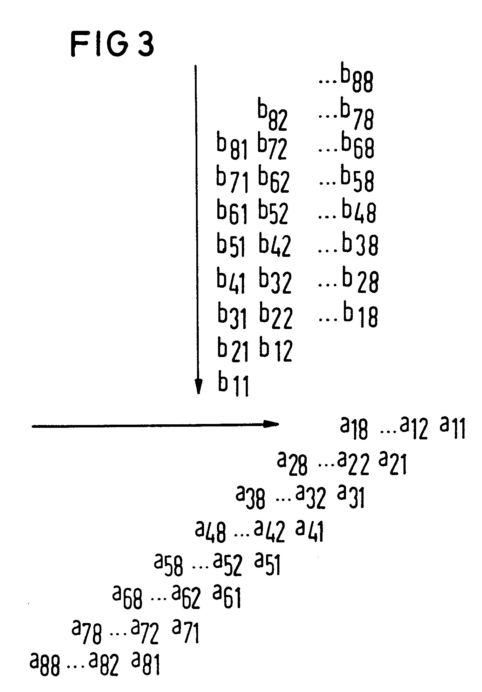

Figur 3 zeigt die Eingangsvariablen, die während des normalen Betriebs bei einer Matrix-Matrix-Multiplikation dem VLSI-System zugeführt werden. Man erkennt, daß die Eingangsvariablen jeder Zeile sowie jeder Spalte jeweils um einen Taktschritt verzögert angelegt werden. Die Zuführung der Eingangsvariablen für die Module in der ersten Zeile ergibt sich daher wie folgt:

Für das Modul in der ersten Spalte und ersten Zeile werden die Eingangsvariablen $a_1 = (a_{11}, a_{12},...a_{18})$ sowie die Eingangsvariablen $b_1 = (b_{11}, b_{21},...b_{81})$ zugeführt. Für das Modul in der zweiten Spalte der ersten Zeile ergeben sich die Eingangsvariablen $a_1 = (a_{11}, a_{12},...a_{18})$ und $b_2 = (b_{12}, b_{22},...b_{82})$. Für das Modul in der letzten Spalte der ersten Zeile ergibt sich für die Eingangsvariablen $a_1 = (a_{11}, a_{12},...a_{18})$ sowie $b_8 = ( b_{18}, b_{28},...b_{88})$. Analog ergeben sich die Eingangsvariablen für die restlichen Module in den übrigen Zeilen. Für die Konfigurationsprozedur ist es am sinnvollsten zum Testen der Module die Eingangsvariablen für jedes Modul gleich zu wählen, um nach den durchgeführten Rechenoperationen eine schnelle und einfache Überprüfung auf ein positives oder negatives Ergebnis durchführen zu können.

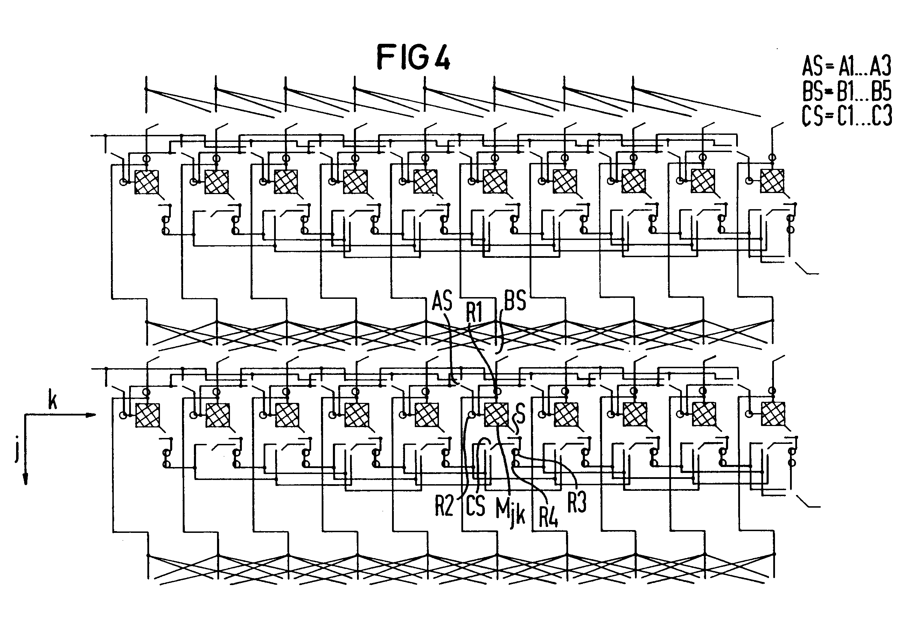

Figur 4 zeigt die Verschaltung der Module untereinander, deren Darstellung in Figur 2 aufgrund der Übersichtlichkeit entfiel. Die Verschaltung des Moduls $M_{jk}$ wird hier stellvertretend für die Verschaltung der übrigen Module in den Zeilen und Spalten des VLSI-Systems angegeben. Das Modul $M_{jk}$ ist an einem Eingang über ein Register R1 an 5 B-Schalter BS, an einem weiteren Eingang über ein Register R2 an drei A-Schalter und am Ausgang über dem Schalter S an zwei in Serie geschaltete Ausgangsregister R3 und R4 angeschlossen. Den Registern vorgelagert befinden sich jeweils die A-Schalter AS, B-Schalter BS und C-Schalter CS. Die A- und C-Schalter stellen Verbindungen der Module untereinander in der Zeile her, während die B-Schalter BS für eine spaltenweise Verschaltung der Module zuständig sind. Eine Verbindung, die einerseits zwischen dem Register R1 und dem zum Register R1 zugehörenden Eingang des Moduls $M_{jk}$ angeschlossen ist, verbindet

andererseits fünf weitere B-Schalter des Moduls in der nächsttieferen j+1-ten Zeile. Diese B-Schalter sind jeweils in der j+1-ten Zeile in der k-2-ten, k-1-ten, k, k+1-ten und k+2-ten Spalte angeordnet. Ebenso verbindet der B-Schalter BS des Moduls $M_{jk}$ fünf weitere in der nächsthöheren j-1-ten Zeile liegen Module, die sich jeweils in der k-2-ten, k-1-ten, k, k+1-ten und k+2-ten Spalte befinden. Mit Hilfe dieser eingeführten "Bypässe", die durch die Verbindungsleitungen und die B-Schalter realisiert sind, ist es möglich, fehlerhafte Module in einer Spalte zu überbrücken. Eine weitere Verbindungsleitung, die zwischen dem Register R2 und dem zum Register R2 zugehörenden Eingang des Moduls $M_{jk}$ angeschlossen ist, verbindet andererseits die A-Schalter der rechts und übernächsten rechts liegenden Module, die sich in der k+1-ten und k+2-ten Spalte derselben Zeile befinden. Die A-Schalter AS, die dem Register R2 vorgeschaltet sind, ermöglichen eine Verbindung wahlweise zum einen zum Eingang des in derselben Zeile links befindlichen Moduls, dem ein weiteres Register analog zum Register R1 zugeordnet ist, in der k-1-ten Spalte, sowie eine Verbindung mit den A-Schaltern der Module in der k-2-ten und k-3-ten Spalte derselben Zeile. Gleichzeitig wird eine Verbindung zu den A-Schaltern der Module in der k+1-ten und k+2-ten Spalte der gleichen Zeile ermöglicht. Der Ausgang des Moduls $M_{jk}$ wird über einen Schalter S auf zwei in Serie geschaltete Ausgangsregister R3 und R4 geschaltet, wobei der Ausgang des Ausgangsregisters R4 eine Verbindung zu weiteren C-Schaltern der rechts und übernächsten rechts liegenden Module in der k+1-ten und k+2-ten Spalte derselben Zeile ermöglicht. Der Schalter S schaltet wahlweise den Ausgang des Moduls $M_{jk}$ oder einen der drei C-Schalter CS des Moduls $M_{jk}$ auf das Ausgangsregister R3. Der C-Schalter CS verbindet weiterhin über den Schalter S das Ausgangsregister R3 wahlweise mit dem in Serie geschalteten zwei Ausgangsregistern der Module, die in der gleichen Zeile, aber k-3-ten, k-2-ten und k-1-ten Spalte angeordnet sind. Gleichzeitig wird eine Verbindung zu den C-Schaltern der Module in der k+1-ten und k+2-ten Spalte der gleichen Zeile ermöglicht. Der A-Schalter AS und der C-Schalter CS des Moduls $M_{jk}$ wird synchron geschaltet, d.h. stellt der A-Schalter AS eine Verbindung zwischen dem Register R2 des Moduls $M_{jk}$ zu dem zum Register R2 zugehörenden Eingang des in der k-1-ten Spalte und der gleichen Zeile angeordneten Moduls her, so stellt der C-Schalter über den Schalter S eine Verbindung mit dem Ausgangsregister R3 des Moduls $M_{jk}$ zu den beiden in Serie geschalteten Ausgangsregistern des in der k-1-ten Spalte und der gleichen Zeile angeordneten Moduls her. Dies gilt übertragen für die verbleibenden restlichen zwei Schalter der A-Schalter AS und C-Schalter CS.

Figur 5 zeigt die erfindungsgemäße Steuerlogik, die in einen fehlerintoleranten Teil SLFI und einen fehlertoleranten Teil SLF aufgespalten ist. Mit Hilfe der Steuerlogik werden die A-, B- und C-Schalter AS, BS, CS des betreffenden Moduls $M_{jk}$ gesteuert. Insgesamt müssen der Steuerlogik zehn logische Variablen zur Verfügung gestellt werden. Der horizontale Steuerleitungsstrang ist hierbei vier Bit breit und umfaßt die logischen Variablen $Z_{j,k-1}$, $C_{j,k-1}$, $\overline{D}_{j,k-1}$ und $\overline{E}_{j,k-1}$ bzw. $Z_{j,k}$, $C_{j,k}$, $\overline{D}_{j,k}$ und $\overline{E}_{j,k}$; der vertikale Steuerleitungsstrang ist sechs Bit breit und ergibt sich aus den logischen Variablen $C_{j,k}$, $\overline{E}_{j-1,k-1}$, $\overline{D}_{j-1,k-1}$, $C_{j-1,k-1}$, $C_{j-1,k}$ und $C_{j-1,k+1}$ bzw. $C_{j+1,k}$, $\overline{E}_{j,k-1}$, $\overline{D}_{j,k-1}$, $C_{j,k-1}$, $C_{j,k}$ und $C_{j,k+1}$. Hierbei ergibt sich eine Definition der logischen Variablen wie folgt:

$C_{j,k}$ = 0, wenn das Modul $M_{jk}$ abgeschaltet ist,
= 1, wenn das Modul $M_{jk}$ eingeschaltet ist,

$E_{j,k}$ = 0, wenn ein Fehler in der Zeile j bis zur Spalte k einschließlich existiert,
= 1, wenn genau ein Fehler in der Zeile j bis zur Spalte k einschließlich existiert,

$D_{j,k}$ = 0, wenn keine zwei Fehler in der Zeile j bis zur Spalte k einschließlich existieren,
= 1, wenn genau zwei Fehler in der Zeile j bis zur Spalte k einschließlich existieren,

$Z_{j,k}$ = 0, wenn höchstens eins der Module $M_{jk-1}$ oder $M_{jk}$ defekt ist,
= 1, wenn beide Module $M_{jk-1}$ und $M_{jk}$ defekt sind.

Hierbei gilt immer, falls die logische Variable D = 1 ist, so ist ebenfalls die logische Variable E = 1, und falls die logische Variable E = 0 ist, so ist ebenfalls die logische Variable D = 0.

Die lokale Steuerlogik wird redundant implementiert. Dies geht nur bei geschickter Zuordnung der A-, B- und C-Schalter AS, BS, CS, indem die Steuerlogik über die Schalter auf das Modul $M_{jk}$ wirkt. Dann wirkt sich ein Fehler in der Steuerlogik nur auf das Modul $M_{jk}$ aus. Der Teil der Steuerlogik SLFI, welche die horizontale Information an den Rest der Zeile weitergibt, ist nicht fehlertolerant, weil ein Fehler von allen restlichen Modulen übernommen würde. Dagegen ist die die vertikale Information verarbeitende Steuerlogik SLF fehlertolerant, weil eine Falschinformation nur bis zum Modul der nächsten Zeile getragen wird und dort neu konfiguriert werden kann. Der fehlertolerante Teil der Steuerlogik SLF ist fünfmal größer als der fehlerintolerante Teil SLFI. Der horizontale Steuerleitungsstrang, welcher die Information an den Rest der Zeile weitergibt, ist vier Bit breit und beinhaltet drei Steuer leitungen, die die logischen Ausgangsvariablen $Z_{j,k}$, $\overline{D}_{j,k}$ und $\overline{E}_{j,k}$ liefern, und aus dem fehlerintoleranten Teil SLFI der Steuerlogik generiert werden. Eine vierte logische Variable $C_{j,k}$ wird hierbei aus dem vertikalen Steuerleitungsstrang über ein Latch L im fehlertoleranten Steuerlogikteil gewonnen. Der vertikale Steuerleitungsstrang, der die Informationen an Module in der nächsten Zeile weitergibt, ist sechs Bit breit und besteht aus den logischen Variablen $\overline{D}_{j,k-1}$, $\overline{E}_{j,k-1}$, $\overline{C}_{j,k-1}$, $C_{j,k}$, $C_{j+1,k}$ und $C_{j,k+1}$. Die ersten vier logischen Variablen werden direkt aus den entsprechenden logischen Eingangsvariablen erzeugt, während die letzten beiden logischen Variablen aus benachbarten Steuerlogiken entnommen werden.

Für die Steuerlogiken, die an der Peripherie des VLSI-Systems angeordnet sind, ergeben sich die Werte für die logischen Variablen durch folgende Anfangsbedingungen:

$C_{0, k-1} = 1$ für $k = 1,...10$;

$E_{0, k-1} = 0$, $D_{0, k-1} = 0$ für $k = 1, ...10$, $C_{1, 0} = 1$, $D_{1, 0} = E_{1, 0} = 0$; $Z_{1, 0} = X$ (don't care), wobei diese logischen Variablen entsprechend den genannten Anfangsbedingungen fest verschaltet werden.

Die logische Variable $C_{j, k}$ wird auf alle Steuerlogiken der k-ten Zeile aufgeschaltet, gleichzeitig bildet sie einen Teil der Selektorbiteingänge SBE aus Figur 2. Weiterhin wird zur Aktivierung der in einer bestimmten Zeile befindlichen Steuerlogik dem fehlertoleranten Teil SLF zusätzlich ein "Enable"-Signal EN bzw. EN' jeweils für die j-te und j+1-te Zeile zugeführt. Da pro Zeile für die Steuerlogiken je ein "Enable"-Signal zugeordnet ist, ergibt sich für das gesamte VLSI-System eine Gesamtanzahl von acht "Enable"-Signalen. Mit Hilfe der logischen Eingangsvariablen $C_{j, k}$ und der "Enable"-Signale ist es möglich, während des Konfigurationsalgorithmusses jedes einzelne Modul in dem VLSI-System zu aktivieren oder außer Betrieb zu setzen.

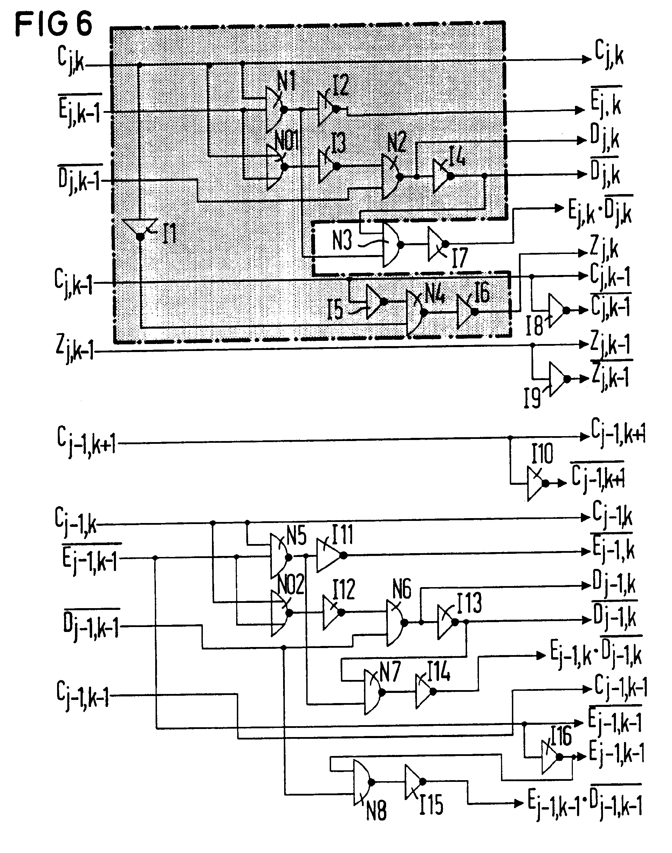

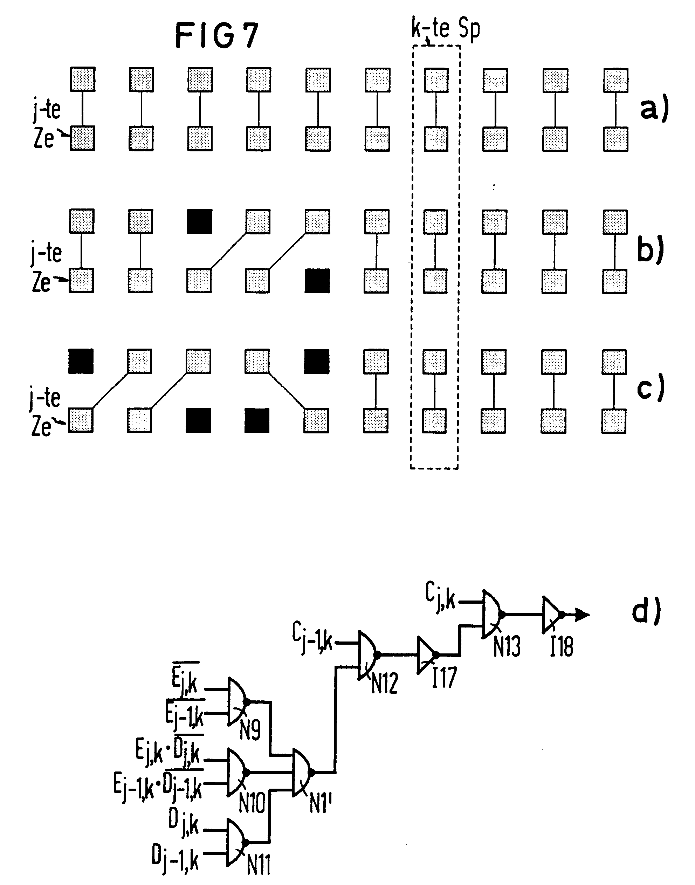

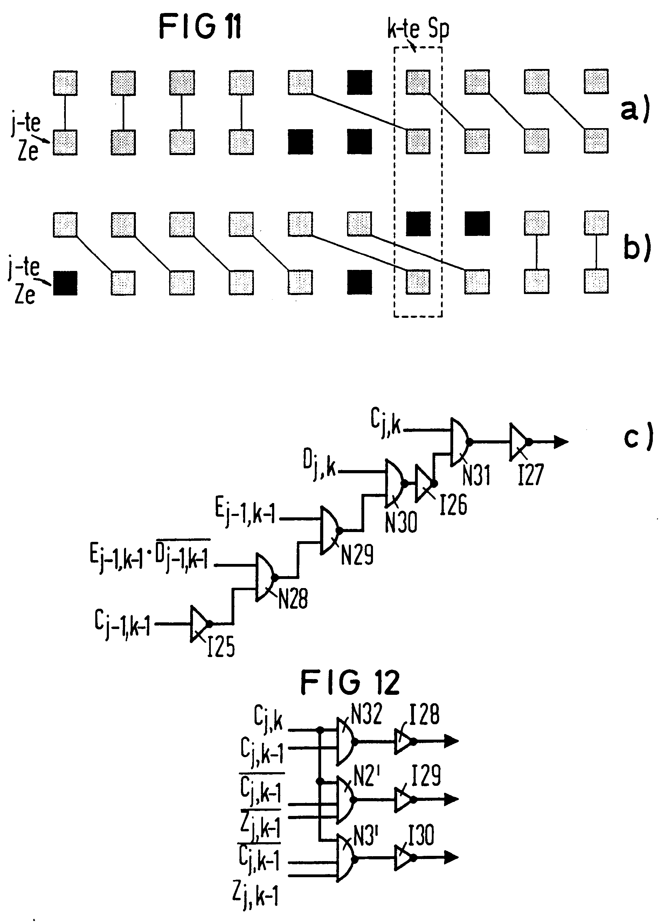

Eine Schaltung auf Gatterebene für die Steuerlogik nach Figur 5 ist in der Figur 6 wiedergegeben. Um die A-, B-, C-Schalter eines jeden Moduls zu steuern, sind insgesamt 21 logische Variablen notwendig, die jedoch aus den zehn bereits in Figur 5 genannten logischen Eingangsvariablen für die Steuerlogik gewonnen werden können. Die zehn logischen Eingangsvariablen für die Steuerlogik sind $C_{j, k}$, $\overline{E}_{j, k-1}$, $\overline{D}_{j, k-1}$, $C_{j, k-1}$, $Z_{j, k-1}$, $C_{j-1, k+1}$, $C_{j-1, k}$, $\overline{E}_{j-1, k-1}$, $\overline{D}_{j-1, k-1}$ und $C_{j-1, k-1}$. Die logischen Ausgangsvariablen der Steuerlogik, deren erste vier fehlerintolerante Ausgangsvariablen darstellen, lauten wie folgt: $C_{j, k}$, $\overline{E}_{j, k}$, $\overline{D}_{j, k}$, $Z_{j, k}$, $D_{j, k}$, $E_{j, k} \cdot \overline{D}_{j, k}$, $C_{j, k-1}$, $\overline{C}_{j, k-1}$, $Z_{j, k-1}$, $\overline{Z}_{j, k-1}$, $C_{j-1, k+1}$, $\overline{C}_{j-1, k+1}$, $C_{j-1, k}$, $\overline{E}_{j-1, k}$, $D_{j-1, k}$, $D_{j-1, k}$, $\overline{E}_{j-1, k} \cdot \overline{D}_{j-1, k}$, $C_{j-1, k-1}$, $\overline{E}_{j-1, k-1}$, $E_{j-1, k-1}$ und $E_{j-1, k-1} \cdot \overline{D}_{j-1, k-1}$. Diese 21 logischen Ausgangsvariablen werden zur Ansteuerung der fünf B-Schalter nach Figur 7d, 8c, 9c, 10c und 11c sowie zur Ansteuerung der A- und C-Schalter nach Figur 12 eingesetzt. Der gestrichelte Teil der Schaltung nach Figur 6 stellt den fehlerintoleranten Teil der Steuerlogik dar, fehlerhafte Gatter oder Inverter in diesem Bereich bedingen Auswirkungen auf die restlichen Steuerlogiken der in der gleichen Zeile angeordneten Module. Ein Fehler in dem fehlertoleranten Teil der Schaltung nach Figur 6 oder in der Gatterlogik für die Steuervariablen zur Ansteuerung der A-, B-, C-Schalter hat keinerlei Auswirkungen auf andere Module und kann einfach durch eine Überbrückung des defekten Moduls mit seiner Steuereinheit umgangen werden.

Die Verschaltung der acht NAND-Gatter, fünfzehn Inverter und einem NOR-Gatter sieht im einzelnen wie folgt aus: Die logische Eingangsvariable $C_{j, k}$ bildet zum einen logische Ausgangsvariable $C_{j, k}$, zum anderen ist sie mit einem ersten Eingang eines ersten NAND-Gatters N1 geschaltet, eine zweite logische Eingangsvariable $\overline{E}_{j, k-1}$ ist mit einem zweiten Eingang des ersten NAND-Gatters N1 und mit einem ersten Eingang eines ersten NOR-Gatters NO1 verschaltet. Die logische Eingangsvariable $C_{j, k}$ ist an den zweiten Eingang des ersten NOR-Gatters NO1 angeschlossen, und die logische Eingangsvariable $\overline{D}_{j, k-1}$ ist mit dem ersten Eingang eines zweiten NAND-Gatters N2 verschaltet. Ein Ausgang des ersten NAND-Gatters N1 ist mit einem ersten Eingang eines dritten NAND-Gatters N3 verbunden und die logische Eingangsvariable $C_{j, k}$ ist über einen ersten Inverter I1 an einen ersten Eingang eines vierten NAND-Gatters N4 angeschlossen. Ein Ausgang des ersten NAND-Gatters N1 liefert über einen zweiten Inverter I2 die logische Ausgangsvariable $\overline{E}_{j, k}$. Ein Ausgang des ersten NOR-Gatters NO1 ist über einen dritten Inverter I3 mit dem zweiten Eingang des zweiten NAND-GAtters N2 verschaltet und ein Ausgang des zweiten NAND-Gatters N2 über einen vierten Inverter I4 ist zum einen mit einem zweiten Eingang des dritten NAND-Gatters N3 verbunden und liefert zum anderen die logische Ausgangsvariable $\overline{D}_{j, k}$. Die logische Eingangsvariable $C_{j, k-1}$ ist über einen fünften Inverter I5 mit einem zweiten Eingang des vierten NAND-Gatters N4 verbunden und ein Ausgang des vierten NAND-Gatters N4 über einen sechsten Inverter I6 liefert die logische Ausgangsvariable $Z_{j, k}$. Der Ausgang des zweiten NAND-Gatters N2 liefert die logische Ausgangsvariable $D_{j, k}$ und ein Ausgang des dritten NAND-Gatters N3 liefert über einen siebten Inverter I7 die logische Ausgangsvariable $E_{j, k} \cdot \overline{D}_{j, k}$. Die logische Eingangsvariable $C_{j, k-1}$ ergibt zum einen die logische Ausgangsvariable $C_{j, k-1}$ und liefert zum anderen über einen achten Inverter I8 die logische Ausgangsvariable $\overline{C}_{j, k-1}$. Die logische Eingangsvariable $Z_{j, k-1}$ bildet zum einen die logische Ausgangsvariable $Z_{j, k-1}$ und liefert weiterhin über einen neunten Inverter I9 die logische Ausgangsvariable $\overline{Z}_{j, k-1}$. Ebenfalls ergibt die logische Eingangsvariable $C_{j-1, k+1}$ die Ausgangsvariable $C_{j-1, k+1}$ und liefert über einen zehnten Inverter I10 die negierte Ausgangsvariable $\overline{C}_{j-1, k+1}$. Die logische Eingangsvariable $C_{j-1, k}$ ergibt weiterhin die logische Ausgangsvariable $C_{j-1, k}$ und ist mit einem ersten Eingang eines fünften NAND-Gatters N5 und mit einem ersten Eingang eines zweiten NOR-Gatters NO2 verschaltet. Die logische Eingangsvariable $\overline{E}_{j-1, k-1}$ ist zum einen mit dem zweiten Eingang des fünften NAND-Gatters N5 und zum anderen mit einem zweiten Eingang des zweiten NOR-Gatters NO2 angeschlossen, der Ausgang des fünften NAND-Gatters N5 liefert über einen elften Inverter I11 die logische Ausgangsvariable $\overline{E}_{j-1, k}$. Der Ausgang des zweiten NOR-Gatters NO2 ist über einen zwölften Inverter I12 mit einem sechsten NAND-Gatter N6 verschaltet, wobei am Ausgang des sechsten NAND-Gatters N6 die logische Ausgangsvariable $D_{j-1, k}$ abgegriffen werden kann und die über einen 13. Inverter I13 die lo-

gische Ausgangsvariable $\overline{D}_{j-1,\,k}$ liefert. Der Ausgang des fünften NAND-Gatters N5 und der Ausgang des 13. Inverters I13 werden jeweils auf einen Eingang eines siebten NAND-Gatters N7 geschaltet und der Ausgang des siebten NAND-Gatters N7 ist an einen 14. Inverter I14 angeschlossen, an dessen Ausgang die logische Ausgangsvariable $E_{j-1,\,k} \cdot \overline{D}_{j-1,\,k}$ abgegriffen werden kann. Die logische Eingangsvariable $\overline{D}_{j-1,\,k-1}$ ist zum einen mit einem zweiten Eingang des sechsten NAND-Gatters N6 und zum anderen an einen ersten Eingang eines achten NAND-Gatters N8 angeschlossen und die logische Eingangsvariable $\overline{E}_{j-1,\,k-1}$ entspricht der logischen Ausgangsvariablen $\overline{E}_{j-1,\,k-1}$ und ist über einen 16. Inverter I16 als logische Ausgangsvariable $E_{j-1,\,k-1}$ abgreifbar. Der Ausgang des 16. Inverters I16 ist mit einem zweiten Eingang des achten NAND-Gatters N8 verschaltet und der Ausgang des achten NAND-Gatters N8 ist auf einen 15. Inverter I15 angekoppelt, an dessem Ausgang die logische Ausgangsvariable $E_{j-1,\,k-1} \cdot \overline{D}_{j-1,\,k-1}$ abgegriffen werden kann. Schließlich bildet die logische Eingangsvariable $C_{j-1,\,k-1}$ ebenfalls die logische Ausgangsvariable $C_{j-1,\,k-1}$.

In den nachfolgenden Figuren werden die Fehlerkonfigurationen beschrieben, welche die A-, B- oder C-Schalter aktivieren, ebenso die Realisierung der zugehörenden Ansteuerlogik. Der jeweilige Ausgang dieser Ansteuerlogik dient zur Aktivierung der entsprechenden Schalter über in den Figuren 7 bis 12 nicht dargestellte "transmission gates".

Die Figuren 7a bis d geben die Fehlerkonfigurationen, welche den Schalter B1 aktivieren, sowie deren Gatterrealisation der zugehörenden logischen Gleichung. an. Der Schalter B1 stellt eine Verbindung des Moduls $M_{j-1,\,k}$ mit dem Modul $M_{j,\,k}$ her, d.h. eine Verbindung zwischen zwei Modulen, die sich in der k-ten Spalte und jeweils in der j-ten und j-1-ten Zeile befinden. Voraussetzung dafür ist, daß beide Module funktionsfähig sind. Die Verbindungslinien zwischen den Modulen nach den Figuren 7a bis 7c deuten an, daß diese Module an den Rechenoperationen, beispielsweise der Matrix-Matrix-Multiplikation teilnehmen und funktionsfähig sind, während solche Module, die in den Figuren 7a bis 7c durch scharz aufgefüllte Quadrate dargestellt sind, und keine Verbindungslinien zu übrigen Modulen aufweisen, defekte oder fehlerhafte Module darstellen. Man erkennt, daß in der Figur 7a kein solches funktionsunfähiges Modul vorhanden ist, im Gegensatz zu Figur 7b, wo pro Zeile je ein defektes Modul und nach Figur 7c je zwei defekte Module pro Zeile auftreten. Zur Aktivierung des B1-Schalters ist es nun wichtig, daß die Einzelfehler nach Figur 7b bzw. die Doppelfehler nach Figur 7c in beiden Zeilen bis zur k-ten Spalte aufgetreten sind. Ist dies der Fall, so stellt der Schalter B1 beispielsweise in der k-ten Spalte die Verbindung zwischen einem Modul $M_{j,\,k}$ und einem Modul $M_{j-1,\,k}$ her, dies bedeutet, beide Module in der k-ten Spalte, die horizontal zueinander liegen, nehmen an den Rechenoperationen, beispielsweise der Matrix-Matrix-Multiplikation teil.

Die logische Definition der Steuervariablen für den B1-Schalter lautet:

$$B1 = C_{j-1,\,k} \cdot C_{j,\,k} \cdot (\overline{E}_{j-1,\,k} \cdot \overline{E}_{j,\,k}) +$$
$$(E_{j-1,\,k} \cdot E_{j,\,k} \cdot \overline{D}_{j-1,\,k} \cdot \overline{D}_{j,\,k}) +$$
$$(D_{j-1,\,k} \cdot D_{j,\,k})).$$

Eine solche Realisierung ist in der Figur 7d auf Gatterebene wiedergegeben. Der B1-Schalter wird durch insgesamt sechs NAND-Gatter N9, N10, N11, N12, N13 und N1′ sowie durch zwei Inverter I17 und I18 aufgebaut. Die logischen Ausgangsvariablen aus der Steuerlogik nach Figur 6 werden hier jeweils an die Eingänge der NAND-Gatter N9, N10, N11, N12 und N13 aufgeschaltet. Die logische Ausgangsvariable $\overline{E}_{j,\,k}$ sowie die logische Ausgangsvariable $\overline{E}_{j-1,\,k}$ wird jeweils auf einen Eingang des neunten NAND-Gatters N9, die logischen Ausgangsvariablen $E_{j,\,k} \cdot \overline{D}_{j,\,k}$ sowie die logischen Ausgangsvariablen $E_{j-1,\,k} \cdot \overline{D}_{j-1,\,k}$ werden jeweils auf einen Eingang des NAND-Gatters N10 und schließlich die logischen Ausgangsvariablen $D_{j,\,k}$ und $D_{j-1,\,k}$ werden auf Eingänge des NAND-Gatters N11 aufgeschaltet. Die Ausgänge des neunten NAND-Gatters N9, des zehnten NAND-Gatters N10 sowie des elften NAND-Gatters N11 werden jeweils auf einen Eingang eines aus drei Eingängen bestehenden NAND-Gatters N1′ geschaltet, dessen Ausgang an einem Eingang des NAND-Gatters N12 anliegt. Der zweite Eingang des NAND-Gatters N12 ist mit der logischen Ausgangsvariablen $C_{j-1,\,k}$ beschaltet, während der Ausgang des zwölften NAND-Gatters N12 über einen 17. Inverter I17 mit einem Eingang des 13. NAND-Gatters N13 verbunden ist. Der zweite Eingang des dreizehnten NAND-Gatters N13 wird mit der logischen Ausgangsvariablen $C_{j,\,k}$ beschaltet und an dem Ausgang des 13. NAND-Gatters N13 ist über einen 18. Inverter I18 das Ausgangssignal für den B1-Schalter abgreifbar.

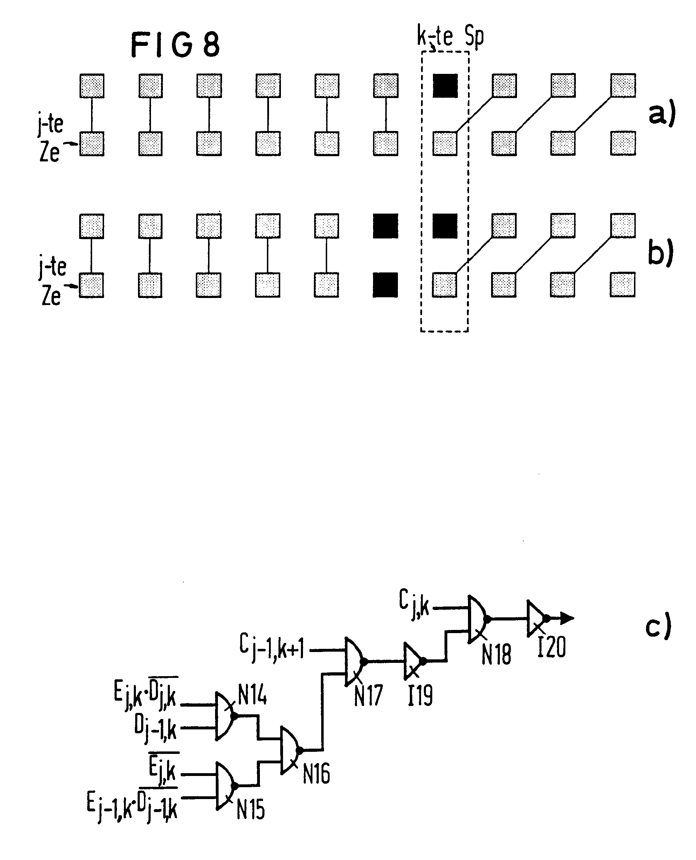

Figur 8a bis 8c geben die Fehlerkonfigurationen an, welche den Schalter B2 aktivieren sowie die Realisierung auf Gatterebene zu seiner Ansteuerung. Fehlerhafte oder defekte Module sind in den Figuren 8a und 8b ebenfalls wieder durch schwarze Quadrate gekennzeichnet. Der B2-Schalter stellt eine Verbindung von Modulen $M_{j-1,\,k+1}$ mit Modulen $M_{j,\,k}$ her. Dies bedeutet eine Verbindung, beispielsweise zwischen einem Modul der j-1-ten Zeile und k+1-ten Spalte zu einem Modul in der j-ten Zeile j-te Ze und k-ten Spalte k-te Sp. Voraussetzung ist, daß beide Module funktionsfähig sind. Aus der Figur 8a erkennt man, daß in der j-1-ten Zeile bis zur k-ten Spalte genau ein defektes Modul auftritt, während in der Figur 8b in j-1-ten Zeile zwei und in der j-ten Zeile ein funktionsunfähiges Modul bis zur k-ten Spalte vorhanden ist. Beiden Figuren gemeinsam ist, daß die Differenz der fehlerhaften Module zwischen der j-1-ten und j-ten Zeile genau 1 beträgt. Der Schalter tritt genau

7

dann in Funktion, wenn diese Differenz bis zur k-ten Stelle einschließlich gerade 1 beträgt.

Die logische Definition der Steuervariablen für den B2-Schalters lautet:

$$B2 = C_{j,\,k} \cdot C_{j-1,\,k-1} \cdot ((E_{j-1,\,k} \cdot \overline{D}_{j-1,\,k}) +$$
$$(E_{j,\,k} \cdot D_{j-1,\,k} \cdot \overline{D}_{j,\,k})).$$

Eine Realisierung entsprechend dieser logischen Definition des B2-Schalters ist in Figur 8 c wiedergegeben. Sie besteht aus insgesamt fünf NAND-Gattern N14, N15, N16, N17 und N18 sowie aus zwei Invertern I19 und I20. Die logischen Ausgangsvariablen aus der Steuerlogik nach Figur 6 werden wieder auf Eingänge dieser NAND-Gatter geschaltet. Die logischen Ausgangsvariablen $E_{j,\,k} \cdot \overline{D}_{j,\,k}$ sowie die logische Ausgangsvariable $D_{j-1,\,k}$ wenn jeweils auf Eingänge des 14. NAND-Gatters N14 und die logischen Ausgangsvariablen aus der Steuerlogik $\overline{E}_{j,\,k}$ und die logischen Ausgangsvariable $E_{j-1,\,k} \cdot \overline{D}_{j-1,\,k}$ je auf Eingänge des 15. NAND-Gatters N15 geschaltet. Die Ausgänge des 14. NAND-Gatters N14 sowie des 15. NAND-Gatters N15 werden jeweils auf Eingänge des 16. NAND-Gatters N16 geschaltet. Dessen Ausgang wiederum ist mit einem Eingang des 17. NAND-Gatters N17 verbunden. Der zweite Eingang des 17. NAND-Gatters N17 ist mit der logischen Ausgangsvariablen $C_{j-1,\,k+1}$ verschaltet und der Ausgang des 17. NAND-Gatters N17 über einen 19. Inverter I19 mit einem Eingang des 18. NAND-Gatters N18 verbunden. Der zweite Eingang dieses 18. NAND-Gatters ist wiederum mit einer logischen Ausgangsvariablen $C_{j,\,k}$ beschaltet und der Ausgang des 18. NAND-Gatters bildet über den 20. Inverter I20 den Ausgang des B2-Schalters.

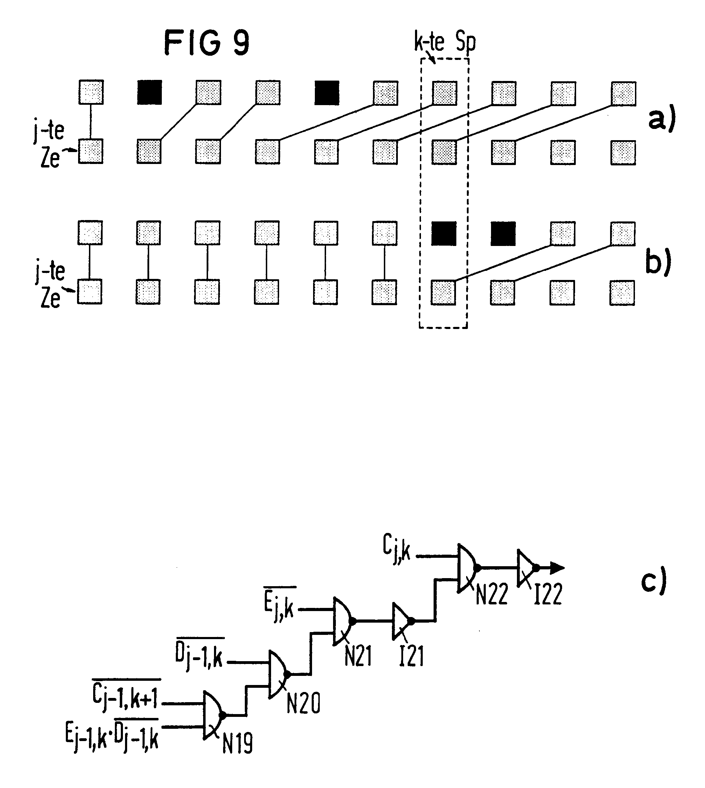

Fehlerkonfigurationen, welche den Schalter B3 aktivieren, sind in den Figuren 9a und 9b und eine Realisation seiner Ansteuerung auf Gatterebene ist in der Figur 9c wiedergegeben. Der Schalter B3 stellt eine Verbindung zwischen einem Modul $M_{j-1,\,k+2}$ zu einem Modul $M_{j,\,k}$ her. Dies bedeutet beispielsweise zwischen einem Modul in der j-1-ten Zeile und k+2-ten Spalte und einem Modul in der j-ten Zeile j-te Ze und k-ten Spalte k-te Sp. Voraussetzung hierfür ist wieder, daß diese Module funktionsfähig sind. Ein Vergleich zwischen den Figuren 9a und 9b zeigt, daß jeweils in beiden Figuren in der j-1-ten Zeile genau zwei funktionsunfähige oder defekte Module auftreten. Der Schalter B3 wird genau dann aktiviert, wenn die Anzahl der defekten Module in der j-1-ten Zeile bis zur k+1-ten Zeile Spalte gerade 2 beträgt. Fehlerhafte Module sind wiederum durch schwarze Quadrate in den Figuren 9a und 9b gekennzeichnet.

Die logische Definition der Steuervariablen für den B3-Schalter lautet:

$$B3 = C_{j,\,k} \cdot \overline{E}_{j,\,k} \cdot (D_{j-1,\,k} + \overline{C}_{j-1,\,k+1} \cdot$$
$$E_{j-1,\,k} \cdot \overline{D}_{j-1,\,k})).$$

Die Realisierung dieser logischen Definition durch vier NAND-Gatter N19, N20, N21 und N22 sowie durch zwei Inverter I21 und I22 ist in Figur 9c wiedergegeben. Logische Ausgangsvariablen aus der Steuerlogik nach Figur 6 werden wiederum auf die vier NAND-Gatter aufgeschaltet. Die logischen Ausgangsvariablen $\overline{C}_{j-1,\,k+1}$, $E_{j-1,\,k} \cdot \overline{D}_{j-1,\,k}$ werden jeweils auf Eingänge des 19. NAND-Gatters N19 geschaltet, dessen Ausgang mit einem Eingang des 20. NAND-Gatters N20 verschaltet ist. Ein zweiter Eingang des 20. NAND-Gatters N20 wird mit der logischen Ausgangsvariable $\overline{D}_{j-1,\,k}$ belegt. Der Ausgang des 20. NAND-Gatters N20 wird auf einen Eingang des 21. NAND-Gatters N21 gelegt, an dessen zweiten Eingang die logische Eingangsvariable $\overline{E}_{j,\,k}$ an liegt. Der Ausgang des 21. NAND-Gatters N21 ist über einen Inverter I21 mit einem Eingang des 22. NAND-Gatters N22 verschaltet. Die logische Ausgangsvariable $C_{j,\,k}$ wird auf den zweiten Eingang des 22. NAND-Gatters N22 geschaltet und der Ausgang des 22. NAND-Gatters N22 bildet über den Inverter I22 den Ausgang des B3-Schalters.

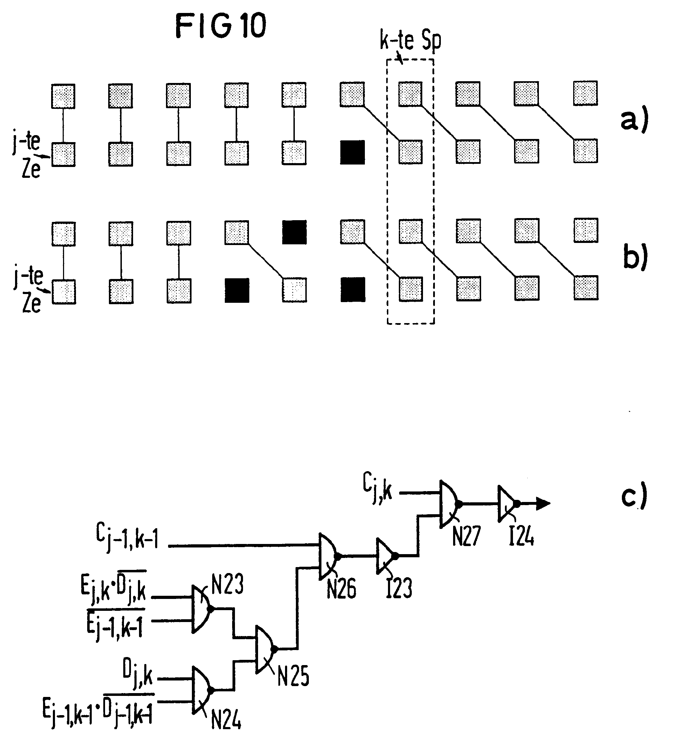

Figur 10a und 10b gibt die Fehlerkonfiguration an, welche den Schalter B4 aktivieren und Figur 10c gibt eine Realisierung seiner Ansteuerung auf Gatterebene wieder. Der Schalter B4 stellt eine Verbindung zwischen einem Modul $M_{j-1,\,k-1}$ und einem Modul $M_{j,\,k}$ her. Dies bedeutet eine Verbindung zwischen einem Modul aus der j-1-ten Zeile und k-1-ten Spalte zu einem Modul in der j-ten Zeile j-te Ze und k-ten Spalte k-te Sp. Voraussetzung hierfür ist wieder, daß beiden Module funktionsfähig sind. Ein Vergleich zwischen den Figuren 10a und 10b zeigt, daß jeweils in der j-ten Zeile ein funktionsunfähiges Modul mehr vorhanden ist als in der j-1-ten Zeile. Der Schalter B4 wird sodann aktiviert, wenn die Differenz der Anzahl der funktionsunfähigen Module zwischen der j-ten und j-1-ten Zeile bis zur k-1-ten Spalte einschließlich gerade 1 beträgt. Fehlerhafte Module sind ebenso wie in den Figuren 7 bis 9 durch schwarz dargestellte Quadrate gekennzeichnet.

Die logische Definition der Steuervariablen für den B4-Schalter lautet:

$$B4 = C_{j-1,\,k-1} \cdot C_{j,\,k} \cdot ((\overline{E}_{j-1,\,k-1} \cdot E_{j,\,k} \cdot \overline{D}_{j,\,k})$$
$$+ (E_{j-1,\,k-1} \cdot \overline{D}_{j-1,\,k-1} \cdot D_{j,\,k})).$$

Die Realisierung dieser logischen Definition ist in Figur 10c wiedergegeben. Sie beinhaltet fünf NAND-Gatter N23, N24, N25, N26 und N27 sowie zwei Inverter I23 und I24. Die logischen Ausgangsvariablen der Steuerlogik nach Figur 6 sind wiederum auf die NAND-Eingänge aufgeschaltet, wobei die logische Ausgangsvariable $D_{j,\,k}$ sowie die Ausgangsvariable $E_{j-1,\,k-1} \cdot \overline{D}_{j-1,\,k-1}$ je auf einen Eingang des 24. NAND-Gatters und die logische Ausgangsvariable $E_{j,\,k} \cdot \overline{D}_{j,\,k}$ sowie $\overline{E}_{j-1,\,k-1}$ auf je einen Eingang des 23. NAND-Gatters geschaltet sind. Der Ausgang des 23. NAND-Gatters N23 und des 24. NAND-Gatters N24 ist jeweils auf einen Eingang des 25. NAND-Gatters N25 gelegt und ein Ausgang des 25. NAND-Gatters ist auf einen Eingang des 26. NAND-Gatters N26 angeschlossen. Ein weiterer Eingang des NAND-Gatters N26 ist mit der logischen Ausgangsvariablen $C_{j-1, k-1}$ belegt und der Ausgang des 26. NAND-Gatters ist über einen 23. Inverter I23 mit einem Eingang des 27. NAND-Gatters N27 verbunden. Auf einen weiteren Eingang des NAND-Gatters N27 ist die logische Ausgangsvariable $C_{j, k}$ aufgeschaltet, der Ausgang des NAND-Gatters N27 bildet über einen Inverter I24 den Ausgang des Schalters B4.

Figur 11a und 11b zeigen Fehlerkonfigurationen, welche den letzten der B-Schalter B5 aktivieren, und Figur 11c zeigt eine Realisierung auf Gatterebene zur Ansteuerung des Schalters B5. Der Schalter B5 stellt eine Verbindung von einem Modul $M_{j-1, k-2}$ und einem Modul $M_{j, k}$ her, d.h. zwischen einem Modul in der j-1-ten Zeile und k-2-ten Spalte und einem Modul in der j-ten Zeile j-te Ze und k-ten Spalte k-te Sp. Voraussetzung hierfür ist, daß das Modul $M_{j,k}$ funktionsfähig ist. Ein Vergleich der Fehlerkonfiguration nach Figur 11a und 11b zeigt, daß jeweils in der j-ten Zeile zwei fehlerhafte Module auftreten, von denen jedoch in Figur 11a zwei fehlerhafte Module unmittelbar hintereinander in einer Zeile folgen und in der Figur 11b in der j-ten Zeile jeweils zwischen einem defekten Modul mindestens ein funktionsfähiges Modul existiert. Zusätzlich tritt nach Figur 11a in der j-1-ten Zeile und k-1-ten Spalte ein fehlerhaftes Modul auf, und in Figur 11b in der j-1-ten Zeile und k-ten Spalte. Der Schalter B5 wird genau dann aktiviert, wenn in der j-1-ten Zeile bis zur k-2-ten Spalte kein fehlerhaftes Modul und in der j-ten Zeile bis zur k-ten Spalte zwei funktionsunfähige Module auftreten.

Die logische Definition der Steuervariablen für den B5-Schalter lautet:

$$B5 = C_{j, k} \cdot D_{j, k} \cdot (\overline{E}_{j-1, k-1} + (E_{j-1, k-1} \cdot \overline{D}_{j-1, k-1} \cdot \overline{C}_{j-1, k-1})).$$

Eine Realisierung dieser logischen Definition auf Gatterebene durch vier NAND-Gatter N28, N29, N30 und N31 sowie durch drei Inverter I25, I26 und I27 ist in der Figur 11c wiedergegeben. Die logische Ausgangsvariable $C_{j-1, k-1}$ wird über einen 25. Inverter I25 einem Eingang des 28. NAND-Gatters N28 zugeführt, an dessen zweiten Eingang die logische Ausgangsvariable $E_{j-1, k-1} \cdot \overline{D}_{j-1, k-1}$ angeschlossen ist. Der Ausgang des NAND-Gatters N28 ist an einen Eingang des 29. NAND-Gatters N29 angeschlossen, auf dessen zeiten Eingang die logische Ausgangsvariable $E_{j-1, k-1}$ aufgeschaltet ist. Der Ausgang des 29. NAND-Gatters ist an einen Eingang des 30. NAND-Gatters N30 geschaltet, dessen zweiter Eingang mit der logischen Ausgangsvariablen $D_{j, k}$ belegt ist. Der Ausgang des NAND-Gatters N30 ist über einen 26. Inverter I26 auf das 31. NAND-Gatter N31 geschaltet, an dessen zweiten Eingang die logische Ausgangsvariable $C_{j, k}$ angeschlossen ist. Der Ausgang des NAND-Gatters N31 wird über einen 27. Inverter I27 geführt und bildet den Ausgang des Schalters B5.

Die Realisierung zur Ansteuerung der drei A- und drei C-Schalter, die jeweils die gleiche Steuerlogik aufweisen, ist in Figur 12 wiedergegeben. Die logischen Gleichungen der Steuervariablen für beide Schalter lauten:

$$A1 \text{ bzw. } C1 = C_{j, k-1} \cdot C_{j, k}$$
$$A2 \text{ bzw. } C2 = \overline{Z}_{j, k-1} \cdot \overline{C}_{j, k-1} \cdot C_{j, k}$$
$$A3 \text{ bzw. } C3 = Z_{j, k-1} \cdot \overline{C}_{j, k-1} \cdot C_{j, k}.$$

Eine Realisierung dieser logischen Gleichungen wird durch drei NAND-Gatter N32, N2′, N3′ sowie durch drei Inverter I28, I29 und I30 ermöglicht. Die logische Ausgangsvariable $C_{j, k}$ sowie $C_{j, k-1}$ ist jeweils auf einen Eingang des 32. NAND-Gatters N32 geschaltet und die logische Ausgangsvariable $C_{j, k}$ ist weiterhin an einen Eingang des aus drei Eingängen bestehenden NAND-Gatters N2′ und an einen Eingang des ebenfalls aus drei Eingängen bestehenden NAND-Gatters N3′ angeschlossen. Weiterhin angeschlossen an das NAND-Gatter N2′ sind jeweils die logischen Ausgangsvariablen $\overline{C}_{j, k-1}$ und $\overline{Z}_{j, k-1}$ und an das NAND-Gatter N3′ die logischen Ausgangsvariablen $\overline{C}_{j, k-1}$ und $Z_{j, k-1}$. Die Ausgänge der drei NAND-Gatter werden jeweils über einen Inverter geführt, so daß der Ausgang des 32. NAND-Gatters über einen 28. Inverter I28 einen ersten Ausgang zur Ansteuerung des A1- bzw. C1-Schalters bildet und der Ausgang des NAND-Gatters N2′ über einen 29. Inverter I29 den zweiten Ausgang zur Ansteuerung des A2- bzw. C2-Schalters. Ebenfalls ist der Ausgang des NAND-Gatters N3′ über einen 30. Inverter I30 verschaltet und bildet den dritten Ausgang zur Ansteuerung des A3- bzw. C3-Schalters.

**Patentansprüche**

1. Vorrichtung zur Herstellung einer testkompatiblen weitgehend fehlertoleranten Konfiguration für redundant implementierte systolische VLSI-Systeme,

bei der die Vorrichtung ein aus N′ in Zeilen und Spalten angeordneten Modulen bestehendes VLSI-System (V), eine Testablaufsteuerung (TC), einen Testbitgenerator (TBG), eine Auswerteeinheit (AE) und einen Selektorbitgenerator (SG) enthält, bei der die Testablaufsteuerung (TC) mit dem VLSI-System über den Selektorbitgenerator (SG) verbunden ist,

bei der der Selektorbitgenerator an seinen Ausgängen spaltenweise mit jedem der Module verschaltet ist, daß die Ausgänge des Testbitgenerators, der die Eingangsvariablen erzeugt, zeilenweise an das VLSI-System angelegt werden,

bei der die Auswerteeinheit zeilenweise mit Ausgängen der Module im VLSI-System verschaltet ist,

bei der jedes Modul in einer Zeile mit Hilfe von je einem A-Schalter an ersten Eingängen und mit je einem C-Schalter an Ausgängen des Moduls mit in der Zeile liegenden nächstliegenden, durch ein Modul oder durch zwei Module getrennt liegendes Modul verschaltet ist,

bei der jedes Modul in einer Zeile mit Hilfe von je einem B-Schalter an einen zweiten Eingang des Moduls, mit einem anderen Modul verbunden ist, das sich in der nächsthöheren Zeile und in einer der Spalten zwischen der vorvorhergehenden und der übernächst folgenden Spalte befindet, wobei die vorvorhergehende und die übernächst folgende Spalte hierbei eingeschlossen ist,

bei der jedem der N' in Zeilen und Spalten angeordneten Moduln eine Steuerlogik zugeordnet ist,

bei der die jeweilige Steuerlogik die A-, B-, C-Schalter für das jeweilige Modul steuert,

bei der jede Steuerlogik in einen fehlertoleranten und fehlerintoleranten Teil aufgespalten ist,

**dadurch gekennzeichnet,**

daß der fehlerintolerante Teil (SLFI) Eingänge für vier fehlerintolerante Logikvariablen und Ausgänge für vier fehlerintolerante Logikvariablen enthält, daß die erste fehlerintolerante Eingangsvariable ($C_{j,k}$) zum einen die erste fehlerintolerante Ausgangsvariable ($C_{j,k}$) bildet, zum anderen an einen ersten Eingang eines ersten NAND-Gatters (N1) geschaltet ist, daß eine zweite fehlerintolerante Eingangsvariable ($\overline{E}_{j,k-1}$) mit einem zweiten Eingang des ersten NAND-Gatters (N1) und mit einem ersten Eingang eines ersten NOR-Gatters (NO1) verschaltet ist, daß die erste fehlerintolerante Eingangsvariable ($C_{j,k}$) an den zweiten Eingang des ersten NOR-Gatters (NO1) angeschlossen ist, daß die dritte fehlerintolerante Eingangsvariable ($\overline{D}_{j,k-1}$) an einen ersten Eingang eines zweiten NAND-Gatters (N2) verschaltet ist, daß ein Ausgang des ersten NAND-Gatters (N1) mit einem ersten Eingang eines dritten NAND-Gatters (N3) angeschlossen ist, daß die erste fehlerintolerante Eingangsvariable ($C_{j,k}$) über einen ersten Inverter (I1) mit einem ersten Eingang eines vierten NAND-Gatters (N4) verschaltet ist, daß ein Ausgang des ersten NAND-Gatters (N1) über einen zweiten Inverter (I2) einen Ausgang für die zweite fehlerintolerante Ausgangsvariable ($\overline{E}_{j,k}$) liefert, daß ein Ausgang des ersten NOR-Gatters (NO1) über einen dritten Inverter (I3) mit dem zweiten Eingang des zweiten NAND-Gatters (N2) verschaltet ist, und ein Ausgang des zweiten NAND-Gatters (N2) über einen vierten Inverter (I4) zum einen mit dem zweiten Eingang des dritten NAND-Gatters (N3) verbunden ist und zum anderen an einem Ausgang des fehlerintoleranten Teils die dritte fehlerintolerante Ausgangsvariable ($\overline{D}_{j,k}$) liefert, daß eine fehlertolerante Eingangsvariable ($C_{j,k-1}$) über einen fünften Inverter (I5) einem zweiten Eingang des vierten NAND-Gatters (N4) zugeführt wird, daß ein Ausgang des vierten NAND-Gatters (N4) über einen sechsten Inverter (I6) die vierte fehlerintolerante Ausgangsvariable ($Z_{j,k}$) liefert, und daß die vierte fehlerintolerante Eingangsvariable ($C_{j-1,k}$) eine fehlertolerante Ausgangsvariable ($C_{j-1,k}$) liefert.

2.  Vorrichtung nach Anspruch 1, **dadurch gekennzeichnet,** daß der fehlertolerante Teil Eingänge für zehn fehlertolerante Eingangsvariablen und Ausgänge für siebzehn fehlertolerante Ausgangsvariablen enthält, daß die erste fehlertolerante Eingangsvariable ($C_{j,k}$) mit der ersten fehlerintoleranten Eingangsvariable, die zweite fehlertolerante Eingangsvariable ($\overline{E}_{j,k-1}$) mit der zweiten fehlerintoleranten Eingangsvariable, die dritte fehlertolerante Eingangsvariable ($\overline{D}_{j,k-1}$) mit der dritten fehlerintoleranten Eingangsvariable und die vierte fehlertolerante Eingangsvariable ($C_{j-1,k}$) mit der vierten fehlerintoleranten Eingangsvariable übereinstimmt, daß der Ausgang des zweiten NAND-Gatters (N2) die erste fehlertolerante Ausgangsvariable ($D_{j,\,k}$) liefert, daß ein Ausgang des dritten NAND-Gatters (N3) über einen siebten Inverter (I7) die zweite fehlertolerante Ausgangsvariable ($E_{j,k} \cdot \overline{D}_{j,\,k}$) liefert, daß die fünfte fehlertolerante Eingangsvariable ($C_{j,\,k-1}$) der fehlertoleranten Eingangsvariable entspricht und zum einen die dritte fehlertolerante Ausgangsvariable ($C_{j,\,k-1}$) und über einen achten Inverter (I8) die vierte fehlertolerante Ausgangsvariable ($\overline{C}_{j,\,k-1}$) liefert, daß die sechste fehlertolerante Eingangsvariable ($Z_{j,k-1}$) die fünfte fehlertolerante Ausgangsvariable ($Z_{j,k-1}$) bildet und über einen neunten Inverter (I9) die sechste fehlertolerante Ausgangsvariable ($\overline{Z}_{j,\,k-1}$) liefert, daß die siebte fehlertolerante Eingangsvariable ($C_{j-1,\,k+1}$) der siebten fehlertoleranten Ausgangsvariable ($C_{j-1,\,k+1}$) entspricht, und über einen zehnten Inverter (I10) die achte fehlertolerante Ausgangsvariable ($\overline{C}_{j-1,\,k+1}$) bildet, daß die vierte fehlertolerante Eingangsvariable ($C_{j-1,\,k}$), die der fehlertoleranten Ausgangsvariablen und der neunten Fehlertoleranten Ausgangsvariablen ($C_{j-1,\,k}$) entspricht, ist mit einem ersten Eingang eines fünften NAND-Gatters (N5) und mit einem ersten Eingang eines zweiten NOR-Gatters (NO2) verschaltet, die achte fehlertolerante Eingangsvariable ($\overline{E}_{j-1,\,k-1}$) ist zum einen mit dem zweiten Eingang des fünften NAND-Gatters (N5) und zum anderen mit einem zweiten Eingang des zweiten NOR-Gatters (NO2) verschaltet, der Ausgang des fünften NAND-Gatters (N5) liefert über einen elften Inverter (I11) die zehnte fehlertolerante Ausgangsvariable ($\overline{E}_{j-1, k}$), der Ausgang des zweiten NOR-Gatters (NO2) ist über einen zwölften Inverter (I12) mit einem sechsten NAND-Gatter (N6) verschaltet, wobei am Ausgang des sechsten NAND-Gatters (N6) die elfte fehlertolerante Ausgangsvariable ($D_{j-1, k}$) abgegriffen werden kann und die über einen 13. Inverter (I13) die zwölfte fehlertolerante Ausgangsvariable ($\overline{D}_{j-1, k}$) liefert, daß der Ausgang des fünften NAND-Gatters (N5) und der Ausgang des 13. Inverters (I13) jeweils an je einen Eingang eines siebten NAND-Gatters (N7) verschaltet sind, daß der Ausgang des siebten NAND-Gatters an einen 14. Inverter (I14) angeschlossen ist, an dessem Ausgnag die 13. fehlertolerante Ausgangsvariable ($E_{j-1, k} \cdot \overline{D}_{j-1, k}$) abgegriffen werden kann, daß die neunte fehlertolerante Eingangsvariable ($\overline{D}_{j-1, k-1}$) zum einen mit einem zweiten Eingang des sechsten NAND-Gatters (N6) und zum anderen mit einem ersten Eingang eines achten NAND-Gatters (N8) angeschlossen ist, daß die achte fehlertolerante Eingangsvariable ($\overline{E}_{j-1, k-1}$) die 15. fehlertolerante Ausgangsvariable ($\overline{E}_{j-1, k-1}$) entspricht und über einen 16. Inverter (I16) die 16. fehlertolerante Ausgangsvariable ($E_{j-1, k-1}$) liefert, daß der Ausgang des 16. Inverters (I16) mit dem zweiten Eingang des achten NAND-Gatters (N8) verschaltet ist, und der Ausgang des achten NAND-Gatters (N8) mit einem 15. Inverter (I15) verschaltet ist, an dessen Ausgang die 17. fehlertolerante Ausgangsvariable ($E_{j-1, k-1} \cdot \overline{D}_{j-1, k-1}$) abgegriffen werden kann, und daß die fehlertolerante Eingangsvariable ($C_{j-1, k-1}$) der 14. fehlertoleranten Ausgangsvariable ($C_{j-1, k-1}$) entspricht.

3.  Vorrichtung nach Anspruch 2, **dadurch gekennzeichnet,** daß der Steuerlogik eines jeden Moduls fünf B-Schalter sowie drei A- und drei C-Schalter zugeordnet sind, daß der erste B-Schalter (B1) eine Verbindung zwischen einem Modul in der j-1-ten Zeile und einem zweiten Modul in der j-ten Zeile herstellt, wobei beide Module horizontal zueinander liegen, daß ein zweiter B-Schalter (B2) eine Verbindung zwischen einem dritten Modul in der j-ten Zeile und einem vierten Modul in der j-1-ten Zeile herstellt, wobei das vierte Modul in der j-1-ten Zeile um ein Modul rechts vom dritten Modul angeordnet ist, daß ein dritter B-Schalter (B3) eine Verbindung zwischen einem fünften Modul in der j-ten Zeile und einem sechsten Modul in der j-1-ten Zeile herstellt, wobei das sechste Modul in der j-1-ten Zeile um zwei Module rechts versetzt vom fünften Modul angeordnet ist, daß ein vierter B-Schalter (B4) eine Verbindung zwischen einem siebten Modul in der j-ten Zeile und einem achten Modul in der j-1-ten Zeile herstellt, wobei das achte Modul in der j-1-ten Zeile um ein Modul links vom siebten Modul angeordnet ist, daß ein fünfter B-Schalter (B5) eine Verbindung zu einem neunten Modul in der j-ten Zeile und zehnten Modul in der j-1-ten Zeile herstellt, wobei das zehnte Modul um zwei Module links versetzt vom neunten Modul angeordnet ist, daß der erste A-Schalter (A1) eine Verbindung zwischen einem Eingang für die ersten Eingangsvariablen eines Moduls in der j-ten Zeile und k-ten Spalte und einen Eingang für die ersten Eingangsvariablen eines weiteren Moduls in der j-ten Zeile und k-1-ten Spalte und zu A-Schalter in der j-ten Zeile und k+1-ten und k+2-ten Spalte, daß der zweite A-Schalter (A2) eine Verbindung zwischen dem Eingang des Moduls in der j-ten Zeile und k-ten Spalte zu einem Eingang für die ersten Eingangsvariablen eines weiteren Moduls in der j-ten Zeile und k-2-ten Spalte und zu A-Schaltern von Module in der j-ten Zeile und k-1-ten Spalte und k+1-ten Spalte, daß der dritte A-Schalter (A3) eine Verbindung zwischen dem Eingang des Moduls in der j-ten Zeile und k-ten Spalte zu einem Eingang für die ersten Eingangsvariablen eines weiteren Moduls in der j-ten Zeile und k-3-ten Spalte und zu A-Schaltern von Modulen in der j-ten Zeile und k-2-ten Spalte und k-1-ten Spalte, daß der erste C-Schalter (C1) eine Verbindung zwischen einem Schalter (S) am Ausgang des Moduls in der j-ten Zeile und k-ten Spalte zu Ausgangsregistern von einem weiteren Modul in der j-ten Zeile und k-1-ten Spalte und zu C-Schaltern von Modulen in der j-ten Zeile und k+1-ten und k+2-ten Spalte, daß der zweite C-Schalter (C2) eine Verbindung zwischen dem Schalter (S) zu Ausgangsregistern von einem weiteren Modul in der j-ten Zeile und k-2-ten Spalte und zu C-Schaltern von Modulen in der j-ten Zeile und k-1-ten und k+1-ten Spalte und daß der dritte C-Schalter (C3) eine Verbindung zwischen dem Schalter (S) zu Ausgangsregistern eines weiteren Moduls in der j-ten Zeile und k-3-ten Spalte und zu C-Schaltern von Modulen in der j-ten Zeile und k-2-ten und k-1-ten Spalte herstellt.

4.  Vorrichtung nach Anspruch 2, **dadurch gekennzeichnet,** daß die Ansteuerung des ersten B-Schalters sechs NAND-Gatter (N9, N10, N11, N12, N13 und N1') sowie zwei Inverter (I17, I18) enthält, daß die zweite fehlerintolerante Ausgangsvariable ($\overline{E}_{j, k}$) und die zehnte fehlertolerante Ausgangsvariable ($\overline{E}_{j-1, k}$) jeweils auf einen Eingang des neunten NAND-Gatters (N9) geschaltet ist, daß die zweite fehlertolerante Ausgangsvariable ($E_{j, k} \cdot \overline{D}_{j, k}$) sowie die 13. fehlertolerante Ausgangsvariable ($E_{j-1, k} \cdot \overline{D}_{j-1, k}$) jeweils mit den Eingängen des zehnten NAND-Gatters (N10) verbunden ist, daß die erste fehlertolerante Ausgangsvariable ($D_{j, k}$) und die elfte fehlertolerante Ausgangsvariable ($D_{j-1, k}$) mit Eingängen des elften NAND-Gatters (N11) verschaltet ist, daß ein Ausgang des neunten NAND-Gatters (N9), des zehnten NAND-Gatters (N10) und des elften NAND-Gatters (N11) jeweils an einen Eingang eines ersten aus drei Eingängen bestehenden NAND-Gatters (N1') angeschlossen ist, daß ein Ausgang des ersten aus drei Eingängen bestehenden NAND-Gatters (N1') mit einem ersten Eingang eines zwölften NAND-Gatters (N12) verschaltet ist, daß auf einen zweiten Eingang des zwölften NAND-Gatters (N12) die neunte fehlertolerante Ausgangsvariable ($C_{j-1, k}$) angeschlossen ist, und der Ausgang des zwölften NAND-Gatters (N12) über einen 17. Inverter (I17) mit einem Eingang des 13. NAND-Gatters (N13) verschaltet ist, daß ein weiterer Eingang des 13. NAND-Gatters (N13) mit einer ersten fehlerintoleranten Ausgangsvariable ($C_{j, k}$) verschaltet ist, und ein Ausgang des 13. NAND-Gatters über einen 18. Inverter (I18) den Ausgang zur Steuerung des ersten B-Schalters bildet.

5. Vorrichtung nach Anspruch 3, **dadurch gekennzeichnet,** daß die Ansteuerung des zweiten B-Schalters fünf NAND-Gatter (N14, N15, N16, N17, N18) sowie zwei Inverter (I19, I20) enthält, daß die zweite fehlertolerante Ausgangsvariable ($E_{j, k} \cdot \overline{D}_{j, k}$) sowie die elfte fehlertolerante Ausgangsvariable ($D_{j-1, k}$) mit einem einem 14. NAND-Gatter (N14) verschaltet ist, daß die zweite fehlerintolerante Ausgangsvariable ($\overline{E}_{j, k}$) und die 13. fehlertolerante Ausgangsvariable ($E_{j-1, k} \cdot \overline{D}_{j-1, k}$) jeweils mit einem Eingang des 15. NAND-Gatters (N15) verschaltet ist, daß je ein Ausgang des 14. NAND-Gatters (N14) und des 15. NAND-Gatters (N15) jeweils an einen Eingang des 16. NAND-Gatters (N16) verschaltet ist, daß ein Ausgang des 16. NAND-Gatters (N16) mit einem Eingang des 17. NAND-Gatters (N17) verschaltet ist, daß ein weiterer Eingang des 17. NAND-Gatters (N17) mit der siebten fehlertoleranten Ausgangsvariablen ($C_{j-1, k+1}$) verschaltet ist, daß ein Ausgang des 17. NAND-Gatters (N17) über einen 19. Inverter (I19) mit einem Eingang des 18. NAND-Gatters (N18) verschaltet ist, daß ein weiterer Eingang des 18. NAND-Gatters (N18) mit der ersten fehlerintoleranten Ausgangsvariablen ($C_{j, k}$) verschaltet ist, und daß ein Ausgang des 18. NAND-Gatters (N18) über einen 20. Inverter (I20) den Ausgang zur Steuerung des zweiten B-Schalters bildet.

6. Vorrichtung nach Anspruch 3, **dadurch gekennzeichnet,** daß die Ansteuerung des dritten B-Schalters vier NAND-Gatter (N19, N20, N21, N22) sowie zwei Inverter (I21, I22) enthält, daß auf das 19. NAND-Gatter (N19) an einen Eingang eine achte fehlertolerante Ausgangsvariable ($\overline{C}_{j-1, k+1}$) und die 13. fehlerintolerante Ausgangsvariable ($E_{j-1, k} \cdot \overline{D}_{j-1, k}$) geschaltet wird, daß ein Ausgang des 19. NAND-Gatters (N19) mit einem Eingang des 20. NAND-Gatters (N20) verschaltet ist, daß ein weiterer Eingang des 20. NAND-Gatters (N20) mit einer zwölften fehlertoleranten Ausgangsvariable ($\overline{D}_{j-1, k}$) verschaltet ist, daß ein Ausgang des 20. NAND-Gatters (N20) mit einem Eingang des 21. NAND-Gatters (N21) verschaltet ist, daß ein weiterer Eingang des 21. NAND-Gatters mit einer zweiten fehlerintoleranten Ausgangsvariable ($\overline{E}_{j, k}$) verschaltet ist, daß ein Ausgang des 21. NAND-Gatters (N21) über einen 21. Inverter (I21) mit einem Eingang eines 22. NAND-Gatter (N22) verschaltet ist, und ein weiterer Eingang des 22. NAND-Gatters (N22) mit der ersten fehlerintoleranten Ausgangsvariablen ($C_{j, k}$) verbunden ist, und ein Ausgang des 22. NAND-Gatters (N22) über einen 22. Inverter (I22) den Ausgang zur Steuerung des dritten B-Schalters bildet.

7. Vorrichtung nach Anspruch 3, **dadurch gekennzeichnet,** daß die Ansteuerung des vierten B-Schalters fünf NAND-Gatter (N23, N24, N25, N26, N27) sowie zwei Inverter (I23, I24) enthält, daß die zweite fehlertolerante Ausgangsvariable ($E_{j, k} \cdot \overline{D}_{j, k}$) und die 15. fehlertolerante Ausgangsvariable ($\overline{E}_{j-1, k-1}$) jeweils mit einem Eingang des 23. NAND-Gatters (N23) und die erste fehlertolerante Ausgangsvariable ($D_{j, k}$) und die 17. fehlertolerante Ausgangsvariable ($E_{j-1, k-1} \cdot \overline{D}_{j-1, k-1}$) mit jeweils einem Eingang des 24. NAND-Gatters (N24) verschaltet ist, daß je ein Ausgang des 23. NAND-Gatters (N23) und des 24. NAND-Gatters (N24) jeweils mit einem Eingang des 25. NAND-Gatters (N25) verschaltet ist, daß ein Ausgang des 25. NAND-Gatters (N25) mit einem Eingang des 26. NAND-Gatters (N26) verschaltet ist, und ein weiterer Eingang des 26. NAND-Gatters (N26) mit der 14. fehlertoleranten Ausgangsvariablen ($C_{j-1, k-1}$) verschaltet ist, und ein Ausgang des 26. NAND-Gatters (N26) über einen 23. Inverter (I23) mit einem Eingang des 27. NAND-Gatters (N27) verschaltet ist, an dessen weiterem Eingang eine erste fehlerintolerante Ausgangsvariable ($C_{j, k}$) angeschlossen ist, und daß an einem Ausgang des 27. NAND-Gatters (N27) über einen 24. Inverter (I24) der Ausgang zur Steuerung des vierten B-Schalters gebildet wird.

8. Vorrichtung nach Anspruch 3, **dadurch gekennzeichnet,** daß die Ansteuerung des fünften B-Schalters vier NAND-Gatter (N28, N29, N30, N31) sowie drei Inverter (I25, I26, I27) enthält, daß eine 14. fehlertolerante Ausgangsvariable ($C_{j-1, k-1}$) über einen 25. Inverter (I25) an einen ersten Eingang eines 28. NAND-Gatters (N28) verschaltet ist, daß ein weiterer Eingang des 28. NAND-Gatters (N28) mit einer 17. fehlertoleranten Ausgangsvariablen ($E_{j-1, k-1} \cdot \overline{D}_{j-1, k-1}$) verschaltet ist, daß ein Ausgang des 28. NAND-Gatters (N28) mit einem Eingang des 29. NAND-Gatters (N29) verschaltet ist, daß ein weiterer Einang des 29. NAND-Gatters (N29) mit einer 15. fehlertoleranten Ausgangsvariablen ($E_{j-1, k-1}$) verschaltet ist, daß ein Ausgang des 29. NAND-Gatters (N29) an einem Eingang des 30. NAND-Gatters (N30) angeschlossen ist, daß ein weiterer Eingang des 30. NAND-Gatters mit einer ersten fehlertoleranten Ausgangsvariablen ($D_{j,\,k}$) verschaltet ist, daß ein Ausgang des 30. NAND-Gatters (N30) über einen 26. Inverter (I26) mit einem Eingang des 31. NAND-Gatter (N31) verbunden ist, daß ein weiterer Eingang des 31. NAND-Gatters (N31) mit der fehlerintoleranten Ausgangsvariablen ($C_{j,\,k}$) verschaltet ist, und ein Ausgang des 31. NAND-GAtters (N31) über einen 27. Inverter (I27) einen Ausgang zur Steuerung des fünften B-Schalters bildet.

9. Vorrichtung nach Anspruch 3, **dadurch gekennzeichnet,** daß die Ansteuerung für die A- und C-Schalter gleich aufgebaut sind, daß sie je ein NAND-Gatter (N32), zwei aus drei Eingängen bestehende NAND-Gatter (N2', N3') sowie drei Inverter (I28, I29, I30) enthalten, daß auf ein 32. NAND-gatter (N32) jeweils die erste fehlerintolerante Ausgangsvariable ($C_{j,\,k}$) und die dritte fehlertolerante Ausgangsvariable ($C_{j,\,k-1}$) geschaltet ist, daß die fehlerintolerante Ausgangsvariable ($C_{j,\,k}$) an einen ersten Eingang des aus drei Eingängen bestehenden zweiten NAND-Gatters (N2') und an einen ersten Eingang eines aus drei Eingängen bestehenden dritten NAND-Gatters (N3') geschaltet ist, daß auf zwei weitere Eingänge des aus drei Eingängen bestehenden zweiten NAND-Gatters (N2') je die vierte fehlertolerante Ausgangsvariable ($\overline{C}_{j,\,k-1}$) und die sechste fehlertolerante Ausgangsvariable ($\overline{Z}_{j,\,k-1}$) geschaltet ist, daß die vierte fehlertolerante Ausgangsvariable ($\overline{C}_{j,\,k-1}$) und die fünfte fehlertolerante Ausgangsvariable ($Z_{j,\,k-1}$) jeweils auf einen Eingang des aus drei Eingängen bestehenden NAND-Gatters (N3') geschaltet ist, daß ein Ausgang des 32. NAND-Gatters (N32) über einen 28. Inverter (I28) einen ersten Ausgang zur Steuerung des ersten A- bzw. C-Schalters (A1, C1) bildet, daß ein Ausgang des aus drei Eingängen bestehenden zweiten NAND-Gatters (N2') über einen 29. Inverter (I29) einen zweiten Ausgang zur Steuerung des zweiten A- bzw. C-Schalters (A2, C2) und ein Ausgang des aus drei Eingängen bestehenden dritten NAND-Gatters (N3') über einen 30. Inverter (I30) einen dritten Ausgang zur Steuerung des dritten A- bzw. C-Schalters (A3, C3) bildet.

## Claims

1. Device for producing a test-compatible largely error-tolerant configuration for redundantly implemented systolic VLSI systems, in the case of which the device contains a VLSI system (V) which comprises N' modules arranged in rows and columns, a test sequence controller (TC), a test bit generator (TBG), an evaluation unit (AE) and a selector bit generator (SG), in the case of which device the test sequence controller (TC) is connected to the VLSI system via the selector bit generator (SG), in the case of which device the selector bit generator is connected at its outputs in columns to each of the modules, in that the outputs of the test bit generator which produces the input variables are applied in rows to the VLSI system, in the case of which device the evaluation unit is connected in rows to outputs of the modules in the VLSI system, in the case of which device each module in a row is connected with the aid of in each case one A switch at first inputs and by means of in each case one C switch at outputs of the module to that module which is located next in the row and is separated by one module or by two modules, in the case of which device each module in a row is connected with the aid of in each case one B switch at a second input of the module to another module which is located in the next higher row and in one of the columns between the next but one preceding column and the next but one following column, the next but one preceding column and the next but one following column in this case being included, in the case of which device a control logic device is assigned to each of the N' modules which are arranged in rows and columns, in the case of which device the respective control logic device controls the A, B, C switches for the respective module, and in the case of which device each control logic device is split into an error-tolerant part and an error-intolerant part, characterized in that the error-intolerant part (SLFI)[2] contains inputs for four error-intolerant logic variables and outputs for four error-intolerant logic variables, in that the first error-intolerant input variable ($C_{j,k}$) on the one hand forms the first error-intolerant output variable ($C_{j,k}$) and on the other hand is connected to a first input of a first NAND gate (N1), in that a second error-intolerant input variable ($\overline{E}_{j,k-1}$) is connected to a second input of the first NAND gate (N1) and to a first input of a first NOR gate (NO1), in that the first error-intolerant input variable ($C_{j,k}$) is connected to the second input of the first NOR gate (NO1), in that the third error-intolerant input variable ($\overline{D}_{j,k-1}$) is connected at a first input of a second NAND gate (N2), in that one output of the first NAND gate (N1) is connected by a first input of a third NAND gate (N3), in that the first error intolerant input variable ($C_{j,k}$) is connected via a first invertor (I1) to a first input of a fourth NAND gate (N4), in that one output of the first NAND gate (N1) supplies, via a second invertor (I2), an output for the second error-intolerant output variable ($\overline{E}_{j,k}$), in that one output of the first NOR gate (NO1) is connected via a third invertor (I3) to the second input of the second NAND gate (N2), and one output of the second NAND gate (N2) is connected via a fourth invertor (I4) on the one hand to the second input of the third NAND gate (N3) and, on the other hand, supplies the third error-intolerant output variable $(\overline{D}_{j,k})$ at one output of the error-intolerant part, in that an error-tolerant input variable $(C_{j,k-1})$ is supplied via a fifth invertor (I5) to a second input of the fourth NAND gate (N4), in that one output of the fourth NAND gate (N4) supplies the fourth error-intolerant output variable $(Z_{j,k})$ via a sixth invertor (I6), and in that the fourth error-intolerant input variable $(C_{j-1,k})$ supplies an error-tolerant output variable $(C_{j-1,k})$.

2. Device according to Claim 1, characterized in that the error-tolerant part contains inputs for ten error-tolerant input variables and outputs for seventeen error-tolerant output variables, in that the first error-tolerant input variable $(C_{j,k})$ corresponds with the first error-intolerant input variable, the second error-tolerant input variable $(\overline{E}_{j,k-1})$ corresponds with the second error-intolerant input variable, the third error-tolerant input variable $(\overline{D}_{j,k-1})$ corresponds with the third error-intolerant input variable, and the fourth error-tolerant input variable $(C_{j-1,k})$ corresponds with the fourth error-intolerant input variable, in that the output of the second NAND gate (N2) supplies the first error-tolerant output variable $(D_{j,k})$ in that one output of the third NAND gate (N3) supplies the second error-tolerant output variable $(E_{j,k} \cdot \overline{D}_{j,k})$ via a seventh invertor (I7), in that the fifth error-tolerant input variable $(C_{j,k-1})$ corresponds to the error-tolerant input variable and supplies on the one hand the third error-tolerant output variable $(C_{j,k-1})$ and, via an eighth invertor (I8), the fourth error-tolerant output variable $(\overline{C}_{j,k-1})$, in that the sixth error-tolerant input variable $(Z_{j,k-1})$ forms the fifth error-tolerant output variable $(Z_{j,k-1})$ and supplies the sixth error-tolerant output variable $(\overline{Z}_{j,k-1})$ via a ninth invertor (I9), in that the seventh error-tolerant input variable $(C_{j-1,k+1})$ corresponds with the seventh error-tolerant output variable $(C_{j-1,k+1})$ and forms the eighth error-tolerant output variable $(\overline{C}_{j-1,k+1})$ via a tenth invertor (I10), in that the fourth error-tolerant input variable $(C_{j-1,k})$, which corresponds with the error-tolerant output variables and with the ninth error-tolerant output variables $(C_{j-1,k})$, is connected to a first input of a fifth NAND gate (N5) and to a first input of a second NOR gate (NO2), the eighth error-tolerant input variable $(\overline{E}_{j-1,k-1})$ is connected on the one hand to the second input of the fifth NAND gate (N5) and on the other hand to a second input of the second NOR gate (NO2), the output of the fifth NAND gate (N5) supplies the tenth error-tolerant output variable $(\overline{E}_{j-1,k})$ via an eleventh invertor (I11), the output of the second NOR gate (NO2) is connected to a sixth NAND gate (N6) via a twelfth invertor (I12), it being possible to pick off the eleventh error-tolerant output variable $(D_{j-1,k})$ at the output of the sixth NAND gate (N6), and which supplies the twelfth error-tolerant output variable $(\overline{D}_{j-1,k})$ via a 13th invertor (I13), in that the output of the fifth NAND gate (N5) and the output of the thirteenth invertor (I13) are in each case connected at in each case one input of a seventh NAND gate (N7), in that the output of the seventh NAND gate is connected to a 14th invertor (I14) at whose output the 13th error-tolerant output variable $(E_{j-1,k} \cdot \overline{D}_{j-1,k})$ can be picked off, in that the ninth error-tolerant input variable $(\overline{D}_{j-1,k-1})$ is connected on the one hand by a second input of the sixth NAND gate (N6) and on the other hand by a first input of an eighth NAND gate (N8), in that the eighth error-tolerant input variable $(\overline{E}_{j-1,k-1})$ corresponds with the 15th error-tolerant output variable $(\overline{E}_{j-1,k-1})$ and supplies the 16th error-tolerant output variable $(E_{j-1,k-1})$ via a 16th invertor (I16), in that the output of the 16th invertor (I16) is connected to the second input of the eighth NAND gate (N8), and the output of the eighth NAND gate (N8) is connected to a 15th invertor (I15) at whose output the 17th error-tolerant output variable $(E_{j-1,k-1} \cdot \overline{D}_{j-1,k-1})$ can be picked off and in that the error-tolerant input variable $(C_{j-1,k-1})$ corresponds with the 14th error-tolerant output variable $(C_{j-1,k-1})$.

3. Device according to Claim 2, characterized in that the control logic device of each module is assigned five B switches as well as three A switches and three C switches, in that the first B switch (B1) produces a connection between a module in the j-1th row and a second module in the jth row, both modules being horizontal with respect to one another, in that a second B switch (B2) produces a connection between a third module in the jth row and a fourth module in the j-1th row, the fourth module in the j-1th row being arranged one module to the right of the third module, in that a third B switch (B3) produces a connection between a fifth module in the jth row and a sixth module in the j-1th row, the sixth module in the j-1th row being arranged displaced two modules to the right of the fifth module, in that a fourth B switch (B4) produces a connection between a seventh module in the jth row and an eighth module in the j-1th row, the eighth module in the j-1th row being arranged one module to the left of the seventh module, in that a fifth B switch (B5) produces a connection to a ninth module in the jth row and a tenth module in the j-1th row, the tenth module being arranged displaced two modules to the left from the ninth module, in that the first A switch (A1) produces a connection between an input for the first input variables of a module in the jth row and kth column and an input for the first input variables of a further module in the jth row and k-1th column and to A switches in the jth row and k+1th column and k+2th column, in that the second A switch (A2) produces a connection between the input of the module in the jth row and the kth column to form an input for the first input variables of a further module in the jth row and k-2th column and to A switches of modules in the jth row and k-1th column and k+1th column, in that the third A switch (A3) produces a connection between the input of the module in the jth row and kth column to form an input for the first input variables of a further module in the jth row and k-3th column and to A switches of modules in the jth row and k-2th column and k-1th column, in that the first C switch (C1) produces a connection between a switch (S) at the output of the module in the jth row and kth column to output registers of a further module in the jth row and k-1th column and to C switches of modules in the jth row and k+1th column and k+2th column, in that the second C switch (C2) produces a connection between the switch (S) to output registers of a further module in the jth row and k-2th column and to C switches of modules in the jth row and k-1th column and k+1th column, and in that the third C switch (C3) produces a connection between the switch (S) to output registers of a further module in the jth row and k-3th column and to C switches of modules in the jth row and k-2th column and k-1th column.

4. Device according to Claim 2, characterized in that the drive of the first B switch contains six NAND gates (N9, N10, N11, N12, N13 and N1') as well as two invertors (I17, I18), in that the second error-intolerant output variable ($\overline{E}_{j,k}$) and the tenth error-tolerant output variable ($\overline{E}_{j-1,k}$) are each connected to one input of the ninth NAND gate (N9), in that the second error-tolerant output variable ($E_{j,k} \cdot \overline{D}_{j,k}$) as well as the 13th error-tolerant output variable ($E_{j-1,k} \cdot \overline{D}_{j-1,k}$) are in each case connected to the inputs of the tenth NAND gate (N10), in that the first error-tolerant output variable ($D_{j,k}$) and the eleventh error-tolerant output variable ($D_{j-1,k}$) are connected to inputs of the eleventh NAND gate (N11), in that one output of the ninth NAND gate (N9), of the 10th NAND gate (N10) and of the eleventh NAND gate (N11) are in each case connected to one input of a first NAND gate (N1') which comprises three inputs, in that one output of the first NAND gate (N1'), which comprises three inputs, is connected to a first input of a twelfth NAND gate (N12), in that the ninth error-tolerant output variable ($C_{j-1,k}$) is connected to a second input of the twelfth NAND gate (N12) and the output of the twelfth NAND gate (N12) is connected via a 17th invertor (I17) to one input of the 13th NAND gate (N13), in that a further input of the 13th NAND gate (N13) is connected to a first error-intolerant output variable ($C_{j,k}$), and an output of the 13th NAND gate forms, via an 18th invertor (I18), the output for controlling the first B switch.

5. Device according to Claim 3, characterized in that the drive of the second B switch contains five NAND gates (N14, N15, N16, N17, N18) as well as two invertors (I19, I20), in that the second error-tolerant output variable ($E_{j,k} \cdot \overline{D}_{j,k}$) as well as the eleventh error-tolerant output variable ($D_{j-1,k}$) are each connected to a 14th NAND gate (N14), in that the second error-intolerant output variable ($\overline{E}_{j,k}$) and the 13th error-tolerant output variable ($E_{j-1,k} \cdot \overline{D}_{j-1,k}$) are in each case connected to one input of the 15th NAND gate (N15), in that in each case one output of the 14th NAND gate (N14) and of the 15th NAND gate (N15) are in each case connected to one input of the 16th NAND gate (N16), in that one output of the 16th NAND gate (N16), is connected to one input of the 17th NAND gate (N17), in that a further input of the 17th NAND gate (N17) is connected to the seventh error-tolerant output variable ($C_{j-1,k+1}$), in that one output of the 17th NAND gate (N17) is connected to one input of the 18th NAND gate (N18) via a 19th invertor (I19), in that a further input of the 18th NAND gate (N18) is connected to the first error-intolerant output variable ($C_{j,k}$) and in that one output of the 18th NAND gate (N18) forms, via an 20th invertor (I20), the output for controlling the second B switch.

6. Device according to Claim 3, characterized in that the drive of the third B switch contains four NAND gates (N19, N20, N21, N22) as well as two invertors (I21, I22), in that an eighth error-tolerant output variable ($\overline{C}_{j-1,k+1}$) and the 13th error-intolerant output variable ($E_{j-1,k} \cdot \overline{D}_{j-1,k}$) are connected to the 19th NAND gate (N19) at one input, in that one output of the 19th NAND gate (N19) is connected to one input of the 20th NAND gate (N20), in that a further input of the 20th NAND gate (N20) is connected to a twelfth error-tolerant output variable ($\overline{D}_{j-1,k}$), in that one input of the 20th NAND gate (N20) is connected to one input of the 21st NAND gate (N21), in that a further input of the 21st NAND gate is connected to a second error-intolerant output variable ($\overline{E}_{j,k}$), in that one output of the 21st NAND gate (N21) is connected via a 21st invertor (I21) to one input of a 22nd NAND gate (N22), and a further input of the 22nd NAND gate (N22) is connected to the first error-intolerant output variable ($C_{j,k}$), and one output of the 22nd NAND gate (N22) forms, via a 22nd invertor (I22), the output for controlling the third B switch.

7. Device according to Claim 3, characterized in that the drive of the fourth B switch contains five NAND gates (N23, N24, N25, N26, N27) as well as two invertors (I23, I24), in that the second error-tolerant output

15

variable ($E_{j,k} \cdot \overline{D}_{j,k}$) and the 15th error-tolerant output variable ($\overline{E}_{j-1,k-1}$) are each connected to one input of the 23rd NAND gate (N23), and the first error-tolerant output variable ($D_{j,k}$) and the 17th error-tolerant output variable ($E_{j-1,k-1} \cdot \overline{D}_{j-1,k-1}$) are connected to in each case one input of the 24th NAND gate (N24), in that in each case one output of the 23rd NAND gate (N23) and of the 24th NAND gate (N24) are in each case connected to one input of the 25th NAND gate (N25), in that one output of the 25th NAND gate (N25) is connected to one input of the 26th NAND gate (N26), and a further input of the 26th NAND gate (N26) is connected to the 14th error-tolerant output variable ($C_{j-1,k-1}$), and one output of the 26th NAND gate (N26) is connected via a 23rd invertor (I23) to one input of the 27th NAND gate (N27), to whose further input a first error-intolerant output variable ($C_{j,k}$) is connected, and in that the output for controlling the fourth B switch is formed at one output of the 27th NAND gate (27), via a 24th invertor (I24).

8.  Device according to Claim 3, characterized in that the drive of the fifth B switch contains four NAND gates (N28, N29, N30, N31) as well as three invertors (I25, I26, I27), in that a 14th error-tolerant output variable ($C_{j-1,k-1}$) is connected via a 25th invertor (I25) to a first input of a 28th NAND gate (N28), in that a further input of the 28th NAND gate (N28) is connected to a 17th error-tolerant output variable ($E_{j-1,k-1} \cdot \overline{D}_{j-1,k-1}$), in that one output of the 28th NAND gate (N28) is connected to one input of the 29th NAND gate (N29), in that a further input of the 29th NAND gate (N29) is connected to a 15th error-tolerant output variable ($E_{j-1,k-1}$), in that one output of the 29th NAND gate (N29) is connected to one input of the 30th NAND gate (N30), in that a further input of the 30th NAND gate is connected to a first error-tolerant output variable ($D_{j,k}$), in that one output of the 30th NAND gate (N30) is connected via a 26th invertor (I26) to one input of the 31st NAND gate (N31), and in that a further input of the 31st NAND gate (N31) is connected to the error-intolerant output variable ($C_{j,k}$), and one output of the 31st NAND gate (N31) forms, via a 27th invertor (I27), an output for controlling the fifth B switch.

9.  Device according to Claim 3, characterized in that the drive for the A and C switches is of identical construction, in that they each contain one NAND gate (N32), two NAND gates (N2', N3') comprising three inputs, and three invertors (I28, I29, I30), in that the first error-intolerant output variable ($C_{j,k}$) and the third error-tolerant output variable ($C_{j,k-1}$) are in each case connected to a 32nd NAND gate (N32), in that the error-intolerant output variable ($C_{j,k}$) is connected to a first input of the second NAND gate (N2'), which comprises three inputs, and to a first input of a third NAND gate (N3'), which comprises three inputs, in that the fourth error-tolerant output variable ($\overline{C}_{j,k-1}$) and the sixth error-tolerant output variable ($\overline{Z}_{j,k-1}$) are in each case connected to two further inputs of the second NAND gate (N2'), which comprises three inputs, in that the fourth error-tolerant output variable ($\overline{C}_{j,k-1}$) and the fifth error-tolerant output variable ($Z_{j,k-1}$) are in each case connected to one input of the NAND gate (N3'), which comprises three inputs, in that one output of the 32nd NAND gate (N32) forms, via a 28th invertor (I28), a first output for controlling the first A switch and C switch respectively (A1, C1), and in that one output of the second NAND gate (N2'), which comprises three inputs, forms, via a 29th invertor (I29), a second output for controlling the second A switch or C switch respectively (A2, C2), and one output of the third NAND gate (N3'), which comprises three inputs, forms, via a thirtieth invertor (I30), a third output for controlling the third A switch or C switch respectively (A3, C3).

**Revendications**

1.  Dispositif pour l'établissement d'une configuration, compatible pour des tests et tolérante du point de vue des défauts, pour des systèmes systoliques VLSI agencés de façon redondante, dans lequel
    le dispositif comporte un système VLSI (V) constitué de N' modules disposés suivant des lignes et des colonnes, une unité de commande d'exécution de test (TC), un générateur de bits de test (TBG), une unité d'évaluation (AE) et un générateur de bits de sélection (SG), l'unité de commande d'exécution de test (TC) étant reliée au système VLSI par l'intermédiaire du générateur de bits de sélection (SG), et
    dans lequel le générateur de bits de sélection est raccordé au niveau de ses sorties, suivant des colonnes, à chacun des modules, les sorties du générateur de bits de test, qui produit les variables d'entrée, étant raccordées suivant des lignes au système VLSI, et
    dans lequel l'unité d'évaluation est raccordée ligne par ligne à la sortie des modules dans le système VLSI, et
    dans lequel chaque module dans une ligne est raccordé à l'aide respectivement d'un interrupteur A situé au niveau de premières entrées et à l'aide respectivement d'un interrupteur C situé au niveau de sorties du module, au module immédiatement suivant dans la ligne ou séparé par un module ou par deux modules, et

dans lequel chaque module dans une ligne est relié, à l'aide respectivement d'un interrupteur B situé au niveau d'une seconde entrée du module, à un autre module qui est situé dans la ligne immédiatement supérieure et dans l'une des colonnes situées entre l'antépénultième colonne et la colonne suivante en second, l'antépénultième colonne suivante en second étant incluses, et

dans lequel une unité logique est associée à chacun des N' modules disposés suivant des lignes et des colonnes, et

dans lequel l'unité logique respective commande les interrupteurs A, B, C pour le module respectif, et

dans lequel chaque unité logique de commande est divisée en une partie tolérante du point de vue des défauts et une partie non tolérante du point de vue des défauts,

caractérisé par le fait

que la partie (SLFI), tolérante du point de vue des défauts, présente des entrées pour quatre variables logiques non tolérantes du point de vue des défauts et des sorties pour des variables logiques non tolérantes du point de vue des défauts, que la première variable d'entrée ($C_{j,k}$) non tolérante du point de vue des défauts, d'une part, forme la première variable de sortie ($C_{j,}$k) non tolérante du point de vue des défauts et, d'autre part, est appliquée à une première entrée d'une première porte NON-ET (N1), qu'une seconde variable d'entrée ($\overline{E}_{j,k-1}$), non tolérante du point de vue des défauts est appliquée à une seconde entrée de la première porte NON-OU (N1) et à une première entrée de la première porte NON-ET (NO1), que la première variable d'entrée ($C_{j,k}$) non tolérante du point de vue des défauts est appliquée à la seconde entrée de la première porte NON-ET (NO1), que la troisième variable d'entrée ($\overline{D}_{j,k-1}$), non tolérante du point de vue des défauts est appliquée à une première entrée d'une seconde porte NON-ET (N2), qu'une sortie de la première porte NON-ET (N1) est raccordée à la première entrée d'une troisième porte NON-ET (N3), que la première variable d'entrée ($C_{j,k}$) non tolérante du point de vue des défauts est appliquée, par l'intermédiaire d'un inverseur (I1), à une première entrée d'une quatrième porte NON-ET (N4), qu'une sortie de la première porte NON-ET (N1) fournit, par l'intermédiaire d'un second inverseur (I2), une sortie pour la seconde variable de sortie ($\overline{E}_{j,k}$) non tolérante du point de vue des défauts, qu'une sortie de la première porte NON-ET (N1) est reliée, par l'intermédiaire d'un troisième inverseur (I3), à la seconde entrée de la seconde porte NON-ET (N2), et qu'une sortie de la seconde porte NON-ET (N2), d'une part, est reliée par l'intermédiaire d'un quatrième inverseur (I4) à la seconde entrée de la troisième porte NON-ET (N3) et, d'autre part, délivre, à une sortie de la partie non tolérante du point de vue des défauts, la troisième variable de sortie ($\overline{D}_{j,k}$) non tolérante du point de vue des défauts, qu'une variable d'entrée ($C_{j,k-1}$) tolérante du point de vue des défauts est envoyée, par l'intermédiaire d'un cinquième inverseur (I5), à une seconde entrée de la quatrième porte NON-ET (N4), qu'une sortie de la quatrième porte NON-ET (N4) délivre, par l'intermédiaire d'un sixième inverseur (N6), la quatrième variable de sortie ($Z_{j,k}$) non tolérante du point de vue des défauts et que la quatrième variable d'entrée ($C_{j-1,k}$) non tolérante du point de vue des défauts délivre une variable de sortie ($C_{j-1,k}$) tolérante du point de vue des défauts.

2.  Dispositif suivant la revendication 1, caractérisé par le fait que la partie tolérante du point de vue des défauts posséde des entrées pour dix variables d'entrée tolérantes du point de vue des défauts et des sorties pour dix-sept variables de sortie tolérantes du point de vue des défauts, que la première variable d'entrée ($C_{j,k}$), tolérante du point de vue des défauts coïncide avec la première variable d'entrée non tolérante du point de vue des défauts, que la seconde variable d'entrée ($\overline{E}_{j,k-1}$) tolérante du point de vue des défauts coïncide avec la seconde variable d'entrée non tolérante du point de vue des défauts, que la troisième variable d'entrée ($\overline{D}_{j,k-1}$) tolérante du point de vue des défauts coïncide avec la troisième variable d'entrée non tolérante du point de vue des défauts et que la quatrième variable d'entrée ($C_{j-1,k}$) tolérante du point de vue des défauts coïncide avec la quatrième variable d'entrée non tolérante du point de vue des défauts, que la sortie de la quatrième porte NON-ET (N2) délivre la première variable de sortie ($D_{j,k}$), tolérante du point de vue des défauts, qu'une sortie de la troisième porte NON-ET (N3) délivre, par l'intermédiaire d'un septième inverseur (I7), la seconde variable de sortie ($E_{j,k}.\overline{D}_{j,k}$) tolérante du point de vue des défauts, que la cinquième variable d'entrée ($C_{j,k-1}$) tolérante du point de vue des défauts correspond à la variable d'entrée tolérante du point de vue des défauts et délivre, d'une part, la troisième variable de sortie ($C_{j,k-1}$) tolérante du point de vue des défauts, et, par l'intermédiaire d'un huitième inverseur (I8), la quatrième variable de sortie ($\overline{C}_{j,k-1}$) tolérante du point de vue des défauts, que la sixième variable d'entrée ($Z_{j,k-1}$) tolérante du point de vue des défauts forme la cinquième variable de sortie ($Z_{j,k-1}$) tolérante du point de vue des défauts et fournit, par l'intermédiaire d'un neuvième inverseur (I9), la sixième variable de sortie ($\overline{Z}_{j,k-1}$) tolérante du point de vue des défauts, que la septième variable d'entrée ($C_{j-1,k+1}$) tolérante du point de vue des défauts correspond à la septième variable de sortie ($C_{j-1,k+1}$) tolérante du point de vue des défauts et forme, par l'intermédiaire d'un dixième inverseur (I10), la huitième variable de sortie

17

($\overline{C}_{j-}1,k+1$) tolérante du point de vue des défauts, que la quatrième variable d'entrée ($C_{j-1,k}$) tolérante du point de vue des défauts, qui correspond à la variable de sortie tolérante du point de vue des défauts et à la neuvième variable de sortie ($C_{j-1,k}$), tolérante du point de vue des défauts, est appliquée à la première entrée d'une cinquième porte NON-OU (N5) et à une première entrée d'une seconde porte NON-OU (NO2), que la huitième variable d'entrée ($\overline{E}_{j-1,k-1}$), tolérante du point de vue des défauts, est appliquée, d'une part, à la seconde entrée de la cinquième porte NON-ET (N5) et, d'autre part, à une seconde entrée de la seconde porte NON-OU (NO2), que la sortie de la cinquième porte NON-ET (N5) délivre, par l'intermédiaire d'un onzième inverseur (I11), la sixième variable de sortie ($\overline{E}_{j-1,k}$), tolérante du point de vue des défauts, que la sortie de la seconde porte NON-ET (NO2) est reliée, par l'intermédiaire d'un douzième inverseur (I12) à une sixième porte NON-ET (N6), la onzième variable de sortie ($D_{j-1,k}$) tolérante du point de vue des défauts et fournissant, par l'intermédiaire d'un 13-ème inverseur (I13), la douzième variable de sortie ($\overline{D}_{j-1,k}$) tolérante du point de vue des défauts, que la sortie de la cinquième porte NON-ET (N5) et la sortie du 13-ème inverseur (I13) sont raccordées à respectivement une entrée d'une septième porte NON-ET (N7), que la sortie de la septième porte NON-ET est raccordée à un 14-ème inverseur (I14), sur la sortie duquel peut être prélevée la 13-ème variable de sortie ($E_{j-1,k} \cdot \overline{D}_{j-1,k}$) tolérante du point de vue des défauts, que la neuvième variable d'entrée ($\overline{D}_{j-1,k-1}$) tolérante du point de vue des défauts est raccordée, d'une part, à une seconde entrée de la sixième porte NON-ET (N6) et, d'autre part, à une première entrée d'une huitième porte NON-ET (N8), que la huitième variable d'entrée ($\overline{E}_{j-1,k-1}$) tolérante du point de vue des défauts correspond à la 15-ème variable de sortie ($\overline{E}_{j-1,k-1}$) tolérante du point de vue des défauts et fournit, par l'intermédiaire d'un 16-ème inverseur (I16), la 16-ème variable de sortie ($E_{j-1,k-1}$) tolérante du point de vue des défauts, que la sortie du 16-ème inverseur (I16) est reliée à la seconde entrée de la huitième porte NON-ET (N8) et que la sortie de la huitième porte NON-ET (N8) est raccordée à un 15-ème inverseur (I15), à la sortie duquel peut être prélevée la 17-ème variable de sortie ($E_{j-1,k-1} \cdot \overline{D}_{j-1,k-1}$) tolérante du point de vue des défauts, et que la variable d'entrée ($C_{j-1,k-1}$), tolérante du point de vue des défauts, correspond à la 14-ème variable de sortie ($C_{j-1,k-1}$) tolérante du point de vue des défauts.

**3.** Dispositif suivant la revendication 2, caractérisé par le fait qu'à l'unité logique de chaque module sont associés cinq interrupteurs B ainsi que trois interrupteurs A et trois interrupteurs C, que le premier interrupteur B (B1) établit une liaison entre un module situé dans la j-1-ème ligne et un second module situé dans la j-ème ligne, les deux modules étant disposés horizontalement l'un à côté de l'autre, qu'un second interrupteur B (B2) établit une liaison entre un troisième module situé dans la j-ème ligne et un quatrième module situé dans la j-1-ème ligne, le quatrième module situé dans la j-1-ème ligne étant disposé en étant décalé d'un module vers la droite par rapport au troisième module, qu'un troisième interrupteur B (B3) établit une liaison entre un cinquième module situé dans la j-ème ligne et un sixième module situé dans la j-1-ème ligne, le sixième module situé dans la j-1-ème ligne étant disposé en étant décalé de deux modules vers la droite par rapport au cinquième module, que le quatrième interrupteur B (B4) établit une liaison entre un septième module situé dans la j-ème ligne et un huitième module situé dans la j-1-ème ligne, le huitième module situé dans la j-1-ème ligne étant disposé en étant décalé d'un module vers la gauche à partir du septième module, qu'un cinquième interrupteur B (B5) établit une liaison avec un neuvième module situé dans la j-ème ligne et un dixième module situé dans la j-1-ème ligne, le dixième module étant décalé de deux modules vers la gauche à partir du neuvième module, que le premier interrupteur A (A1) établit une liaison entre une entrée pour la première variable d'entrée d'un module situé dans la j-ème ligne et la k-ème colonne et une entrée pour la première variable d'entrée d'un autre module situé dans la j-ème ligne et la k-1-ème colonne et avec les interrupteurs A situés dans la j-ème ligne et les k+1-ème et k+2-ème colonnes, que le second interrupteur A (A2) établit une liaison entre l'entrée du module situé dans la j-ème ligne et la k-ème colonne et une entrée pour la première variable d'entrée d'un autre module situé dans la j-ème ligne et la k-2-ème colonne et en direction d'interrupteurs A de modules situés dans la j-ème ligne et dans les k-1-ème colonne et k+1-ème colonne, que le troisième interrupteurs A (A3) établit une liaison entre l'entrée du module situé dans la j-ème ligne et la k-ème colonne et une entrée pour la première variable d'entrée d'un autre module dans la j-ème ligne et la k-3-ème colonne et avec des interrupteurs A de modules situés dans la j-ème ligne et les k-2-ème colonne et k-1-ème colonne, que le premier interrupteur C (C1) établit une liaison entre un interrupteur (S) situé à la sortie du module dans la j-ème ligne et la k-ème colonne et des registres de sortie d'un autre module situé dans la j-ème ligne et la k-1-ème colonne et avec des interrupteurs C de modules situés dans la j-ème ligne et les k-1-ème et k+2-ème colonnes, que le second interrupteur C (C2) établit une liaison entre l'interrupteur (S) et des registres assortis d'un autre module dans la j-ème ligne et la k-2-ème colonne et en direction d'interrupteurs C de modules situés dans la j-ème ligne et les k-1-ème et k+1-ème colonnes, et que le troisième interrupteur C (C3) établit une liaison entre l'interrupteur (S) et des registres de sortie d'un autre module dans la j-ème ligne et la k-3-ème colonne et des interrupteurs C de modules situés dans la j-ème ligne et les k-2-ème et k-1-ème colonnes.

4. Dispositif suivant la revendication 2, caractérisé par le fait que la commande ou attaque du premier interrupteur B comporte six portes NON-ET (N9, N10, N11, N12, N13 et N1') ainsi que deux inverseurs (I17, I18), que la seconde variable de sortie ($\overline{E}_{j,k}$) non tolérante du point de vue des défauts et la dixième variable de sortie ($\overline{E}_{j-1,k}$) tolérante du point de vue des défauts sont appliquées chacune à une entrée de la neuvième porte NON-ET (N9), que la seconde variable de sortie ($E_{j,k} \cdot \overline{D}_{j,k}$) tolérante du point de vue des défauts ainsi que la 13-ème variable de sortie ($E_{j-1,k} \cdot \overline{D}_{j-1,k}$) tolérante du point de vue des défauts sont reliées respectivement aux entrées de la dixième porte NON-ET (N10), que la première variable de sortie ($D_{j,k}$) tolérante du point de vue des défauts et la onzième variable de sortie ($D_{j-1,k}$), tolérante du point de vue des défauts est appliquée à des entrées de la onzième porte NON-ET (N11), qu'une sortie de la neuvième porte NON-ET (N9), de la dixième porte NON-ET (N10) et d'une porte NON-ET (N11) est raccordée respectivement à une entrée d'une première porte NON-ET (N1') constituée de trois entrées, qu'une sortie de la première porte NON-ET (N1') constituée de trois entrées est raccordée à une première entrée d'une douzième porte NON-ET (N12), que la neuvième variable de sortie ($C_{j-1,k}$), tolérante du point de vue des défauts est appliquée à une seconde entrée de la douzième porte NON-ET (N12), et que la sortie de la douzième porte NON-ET (N12) est appliquée, par l'intermédiaire d'un 17-ème inverseur (I17), à une entrée de la 13-ème porte NON-ET (N13), qu'une autre entrée de la 13-ème porte NON-ET (N13) reçoit une première variable de sortie ($C_{j,k}$) non tolérante du point de vue des défauts et qu'une sortie de la 13-ème porte NON-ET forme, par l'intermédiaire d'un 18-ème inverseur (I18), la sortie pour la commande du premier interrupteur B.

5. Dispositif suivant la revendication 3, caractérisé par le fait que l'unité de commande ou d'attaque du deuxième interrupteur comporte cinq portes NON-ET (N14, N15, N16, N17, N18) ainsi que deux inverseurs (I19, I20), que la seconde variable de sortie ($E_{j,k} \cdot \overline{D}_{j,k}$) tolérante du point de vue des défauts ainsi que la onzième variable de sortie ($D_{j-1,k}$), tolérante du point de vue des défauts sont appliquées à une 14-ème porte NON-ET (N14), que la seconde variable de sortie ($\overline{E}_{j,k}$) non tolérante du point de vue des défauts et la 13-ème variable de sortie ($E_{j-1,k} \cdot \overline{D}_{j-1,k}$) tolérante du point de vue des défauts sont appliquées respectivement à une entrée de la 15-ème porte NON-ET (N15), que respectivement une sortie de la 14-ème porte NON-ET (N14) et de la 15-ème porte NON-ET (N15) sont raccordées respectivement à une sortie de la 16-ème porte NON-ET (N16), qu'une sortie de la 16-ème porte NON-ET (N16) est raccordée à une entrée de la dix-septième porte NON-ET (N17), qu'une autre entrée de la 17-ème porte NON-ET (N17) reçoit la septième variable de sortie ($C_{j-1,k+1}$), tolérante du point de vue des défauts, qu'une sortie de la 17-ème porte NON-ET (N17) est reliée par l'intermédiaire d'un 19-ème inverseur (I19) à une entrée de la 18-ème porte NON-ET (N18), qu'une autre entrée de la 18-ème porte NON-ET (N18) reçoit la première variable de sortie ($C_{j,k}$) non tolérante du point de vue des défauts et qu'une sortie de la 18-ème porte NON-ET (N18) forme, par l'intermédiaire d'un 20-ème inverseur (I20), la sortie pour la commande du second interrupteur B.

6. Dispositif suivant la revendication 3, caractérisé par le fait qu'une unité de commande ou d'attaque du troisième interrupteur B posséde quatre portes NON-ET (N19, N20, N21, N22) ainsi que deux inverseurs (I21, I22), qu'une huitième variable de sortie ($\overline{C}_{j-1,k+1}$) tolérante du point de vue des défauts et la 13-ème variable de sortie ($E_{j-1,k} \cdot \overline{D}_{j-1,k}$) non tolérante du point de vue des défauts, sont appliquées à une entrée de la 19-ème porte NON-ET (N19), qu'une sortie de la 19-ème porte NON-ET (N19) est reliée à une entrée de la 20-ème porte NON-ET (N20), qu'une autre entrée de la 20-ème porte NON-OU (N20) reçoit une douzième variable de sortie ($\overline{D}_{j-1,k}$) tolérante du point de vue des défauts, qu'une sortie de la 20-ème porte NON-ET (N20) est reliée à une entrée de la 21-ème porte NON-ET (N21), qu'une autre entrée de la 21-ème porte NON-ET reçoit une seconde variable de sortie ($\overline{E}_{j,k}$) non tolérante du point de vue des défauts, qu'une sortie de la 21-ème porte NON-ET (21) est raccordée, par l'intermédiaire d'un 21-ème inverseur (I21), à une entrée d'une 22-ème porte NON-ET (N22), et qu'une seconde entrée de la 22-ème porte NON-ET (N22) reçoit une première variable de sortie ($C_{j,k}$) non tolérante du point de vue des défauts, et qu'une sortie de la 22-ème porte NON-ET (N22) forme, par l'intermédiaire d'un 22-ème inverseur (I22), la sortie pour la commande ou d'attaque du troisième interrupteur B.

7. Dispositif suivant la revendication 3, caractérisé par le fait que la commande ou attaque du quatrième interrupteur B posséde cinq portes NON-ET (N23, N24, N25, N26, N27) ainsi que deux inverseurs (I23, I24), que la seconde variable de sortie ($E_{j,k}, \overline{D}_{j,k}$) tolérante du point de vue des défauts et la 15-ème variable

de sortie ($\overline{E}_{j-1,k-1}$) tolérante du point de vue des défauts sont appliquées respectivement à une entrée de la 23-ème porte NON-ET (N23) et que la première variable de sortie ($D_{j,k}$) tolérante du point de vue des défauts et la 17-ème variable de sortie ($E_{j-1,k-1}.\overline{D}_{j-1,k-1}$) tolérante du point de vue des défauts sont appliquées respectivement à une entrée de la 24-ème porte NON-ET (N24), que respectivement une sortie de la 23-ème porte NON-ET (N23) et de la 24-ème porte NON-OU (N24) sont reliées respectivement à une entrée de la 25-ème porte NON-ET (N25), qu'une sortie de la 25-ème porte NON-ET (N25) est reliée à une entrée de la 26-ème porte NON-ET (N26) et qu'une autre entrée de la 26-ème porte NON-ET (N26) reçoit la 14-ème variable de sortie ($C_{j-1,k-1}$) tolérante du point de vue des défauts, et qu'une sortie de la 26-ème porte NON-ET (N26) est reliée, par l'intermédiaire d'un 23-ème inverseur (I23), à une entrée de la 27-ème porte NON-ET (N27), à l'autre entrée de laquelle est appliquée une première variable de sortie ($C_{j,k}$) non tolérante du point de vue des défauts et que le signal de sortie pour la commande ou attaque du quatrième interrupteur B est formé à partir d'une sortie de la 27-ème porte NON-ET (N27) par l'intermédiaire d'un 24-ème inverseur (I24).

8. Dispositif suivant la revendication 3, caractérisé par le fait que la commande ou attaque du cinquième interrupteur B posséde quatre portes NON-ET (N28, N29, N30, N31) ainsi que trois inverseurs (I25, I26, I27), qu'une 14-ème variable de sortie ($C_{j-1,k-1}$) tolérante du point de vue des défauts est appliquée par l'intermédiaire d'un 25-ème inverseur (I25) à une première entrée d'une 28-ème porte NON-ET (N28), qu'une autre entrée de la 28-ème porte NON-ET (N28) reçoit une 17-ème variable de sortie ($E_{j-1,k-1}.\overline{D}_{j-1,k-1}$), tolérante du point de vue des défauts, qu'une sortie de la 28-ème porte NON-ET (N28) est reliée à une entrée de la 29-ème porte NON-ET (N29), qu'une autre entrée de la 29-ème porte NON-ET (N29) est reliée à une 15-ème variable de sortie ($E_{j-1,k-1}$) tolérante du point de vue des défauts, qu'une sortie de la 29-ème porte NON-ET (N29) est raccordée à une entrée de la 30-ème porte NON-ET (N30), qu'une autre entrée de la 30-ème porte NON-ET est reliée à une première variable de sortie ($D_{j,k}$) tolérante du point de vue des défauts, qu'une sortie de la 30-ème porte NON-ET (N30) est reliée, par l'intermédiaire d'un 26-ème inverseur (I26), à une entrée de la 31-ème porte NON-ET (N31), qu'une autre entrée de la 31-ème porte NON-ET (N31) reçoit la variable de sortie ($C_{j,k}$) non tolérante du point de vue des défauts, et qu'une sortie de la 31-ème porte NON-ET (N31) forme, par l'intermédiaire d'un 27-ème inverseur (I27), une sortie pour la commande du cinquième interrupteur B.

9. Dispositif suivant la revendication 3, caractérisé par le fait que les unités de commande ou d'attaque pour les interrupteurs A et C possèdent la même constitution, qu'ils contiennent chacun une porte NON-ET (N32), deux portes NON-ET (N2',N3') constituées de trois entrées, ainsi que trois inverseurs (I28,I29,I30), que respectivement la première variable de sortie ($C_{j,k}$) non tolérante du point de vue des défauts et la troisième variable de sortie ($C_{j,k-1}$) tolérante du point de vue des défauts sont appliquées à une 32-ème porte NON-ET (N32), que la variable de sortie ($C_{j,k}$) non tolérante du point de vue des défauts est appliquée à une première entrée de la seconde porte NON-ET (N2'), constituée de trois entrées, et à une première entrée d'une troisième porte NON-ET (N3') constituée de trois entrées, que respectivement la quatrième variable de sortie ($\overline{C}_{j,k-1}$) tolérante du point de vue des défauts et la sixième variable de sortie ($\overline{Z}_{j,k-1}$) tolérante du point de vue des défauts sont appliquées à deux autres entrées de la seconde porte NON-ET (N2') constituée de trois entrées, que la quatrième variable de sortie ($\overline{C}_{j,k-1}$) tolérante du point de vue des défauts et la cinquième variable de sortie ($Z_{j,k-1}$) tolérante du point de vue des défauts sont appliquées respectivement à une entrée de la porte NON-ET (N3') constituée de trois entrées, qu'une sortie de la 32-ème porte NON-ET (N32) forme, par l'intermédiaire d'un 28-ème inverseur (I28), une première sortie pour la commande du premier interrupteur A ou C (A1, C1), qu'une sortie de la seconde porte NON-ET (N2'), constituée de trois entrées, forme, par l'intermédiaire d'un 29-ème inverseur (I29), une seconde sortie pour la commande du second interrupteur A ou C (A2, C2) et qu'une sortie de la troisième porte NON-ET (N3') constituée de trois entrées forme, par, l'intermédiaire d'un 30-ème inverseur (I30), une troisième sortie pour la commande du troisième interrupteur A ou C (A3, C3).

# FIG 1

EP 0 308 660 B1

# FIG 2

# FIG 3

$$...b_{88}$$
$$b_{82} \quad ...b_{78}$$
$$b_{81} \; b_{72} \quad ...b_{68}$$
$$b_{71} \; b_{62} \quad ...b_{58}$$
$$b_{61} \; b_{52} \quad ...b_{48}$$
$$b_{51} \; b_{42} \quad ...b_{38}$$
$$b_{41} \; b_{32} \quad ...b_{28}$$
$$b_{31} \; b_{22} \quad ...b_{18}$$
$$b_{21} \; b_{12}$$
$$b_{11}$$

$$a_{18} \; ...a_{12} \; a_{11}$$
$$a_{28} \; ...a_{22} \; a_{21}$$
$$a_{38} \; ...a_{32} \; a_{31}$$
$$a_{48} \; ...a_{42} \; a_{41}$$
$$a_{58} \; ...a_{52} \; a_{51}$$
$$a_{68} \; ...a_{62} \; a_{61}$$
$$a_{78} \; ...a_{72} \; a_{71}$$
$$a_{88} \; ...a_{82} \; a_{81}$$

FIG 4

AS = A1...A3
BS = B1...B5
CS = C1...C3

AS R1 BS

R2 CS Mjk R4

R3

k

i

**FIG 5**

$\overline{E_{j-1,k-1}}$  $\overline{D_{j-1,k-1}}$  $C_{j-1,k-1}$  $C_{j-1,k}$  $C_{j-1,k+1}$

EN

$C_{j,k}$

$Z_{j,k-1}$

$C_{j,k-1}$

$\overline{D_{j,k-1}}$

$\overline{E_{j,k-1}}$

L

SLF

SLF I

$Z_{j,k}$

$C_{j,k}$

$\overline{D_{j,k}}$

$\overline{E_{j,k}}$

$C_{j+1,k}$  $\overline{E_{j,k-1}}$  $\overline{D_{j,k-1}}$  EN'  $C_{j,k-1}$  $C_{j,k}$  $C_{j,k+1}$

EP 0 308 660 B1

# FIG 6

## FIG 7

k-te Sp

j-te
Ze
a)

j-te
Ze
b)

j-te
Ze
c)

d)

$\overline{E_{j,k}}$
$\overline{E_{j-1,k}}$ — N9

$E_{j,k} \cdot \overline{D_{j,k}}$
$E_{j-1,k} \cdot \overline{D_{j-1,k}}$ — N10

$D_{j,k}$
$D_{j-1,k}$ — N11

N1'

$C_{j-1,k}$ — N12 — I17

$C_{j,k}$ — N13 — I18

# F I G 8

k-te Sp

j-te Ze

a)

j-te Ze

b)

c)

$C_{j,k}$ — N18 — I20

$C_{j-1,k+1}$ — N17 — I19

$E_{j,k} \cdot \overline{D_{j,k}}$ — N14

$D_{j-1,k}$

N16

$\overline{E_{j,k}}$ — N15

$E_{j-1,k} \cdot \overline{D_{j-1,k}}$

FIG 9

a)

j-te
Ze

b)

k-te Sp

c)

$C_{j,k}$ — N22 — I22

$\overline{E_{j,k}}$ — N21 — I21

$\overline{D_{j-1,k}}$ — N20

$\overline{C_{j-1,k+1}}$
$E_{j-1,k}\cdot\overline{D_{j-1,k}}$ — N19

# FIG 10

k-te Sp

j-te Ze

a)

j-te Ze

b)

c)

## FIG 11

j-te Ze

k-te Sp

a)

j-te Ze

b)

$C_{j,k}$

$D_{j,k}$

$E_{j-1,k-1}$

$E_{j-1,k-1} \cdot \overline{D_{j-1,k-1}}$

$C_{j-1,k-1}$

N31  I27

N30  I26

N29

N28

I25

c)

## FIG 12

$C_{j,k}$

$C_{j,k-1}$

$\overline{C_{j,k-1}}$

$\overline{Z_{j,k-1}}$

$\overline{C_{j,k-1}}$

$Z_{j,k-1}$

N32  I28

N2'  I29

N3'  I30